Europäisches Patentamt

European Patent Office

Office européen des brevets

(19)

(11) Veröffentlichungsnummer: **0 491 691 B1**

# (12) EUROPÄISCHE PATENTSCHRIFT

(45) Veröffentlichungstag der Patentschrift: **08.06.94**

(51) Int. Cl.⁵: **H02M 1/12**

(21) Anmeldenummer: **90900859.1**

(22) Anmeldetag: **12.12.89**

(86) Internationale Anmeldenummer:
**PCT/EP89/01525**

(87) Internationale Veröffentlichungsnummer:
**WO 91/03864 (21.03.91 91/07)**

(54) **VERFAHREN UND VORRICHTUNG ZUR ERFASSUNG VON RESONANZMESSGRÖSSEN EINES AN EINEM STROMRICHTER ANGESCHLOSSENEN NETZES.**

(30) Priorität: **11.09.89 DE 3930294**
**11.09.89 DE 3930295**
**11.09.89 DE 8911681 U**
**11.09.89 DE 8911680 U**

(43) Veröffentlichungstag der Anmeldung:
**01.07.92 Patentblatt 92/27**

(45) Bekanntmachung des Hinweises auf die
Patenterteilung:
**08.06.94 Patentblatt 94/23**

(84) Benannte Vertragsstaaten:
**CH DE LI**

(56) Entgegenhaltungen:
**US-A- 3 883 792**

**2nd European Conference on Power Electronics and Applications, vol. 2, September 1987, Grenoble, pp. 1239-1244 ; Holtz & Klein : "The propagation of harmonic currents generated by inverter-fed locomotives in the distributed overhead supply system".**

**IEEE Proceedings, vol. 133, no. 2, March 1986, pp. 85-94 ; Taufig, Mellit & Goodman : "Novel algorithm for generating near optimal PWM waveforms for AC traction drives".**

(73) Patentinhaber: **SIEMENS AKTIENGESELL-SCHAFT**
**Wittelsbacherplatz 2**
**D-80333 München(DE)**

(72) Erfinder: **HOLTZ, Joachim**
**Am Forsthof 16**
**D-5600 Wuppertal(DE)**

EP 0 491 691 B1

**Beschreibung**

Die Erfindung betrifft ein Verfahren und eine Vorrichtung zur Bestimmung von Meßgrößen für die Resonanzen in einem Versorgungsnetz, dessen momentane Impedanz unbekannt ist und mit dem der netzseitige Anschluß eines Stromrichtergerätes verbunden ist.

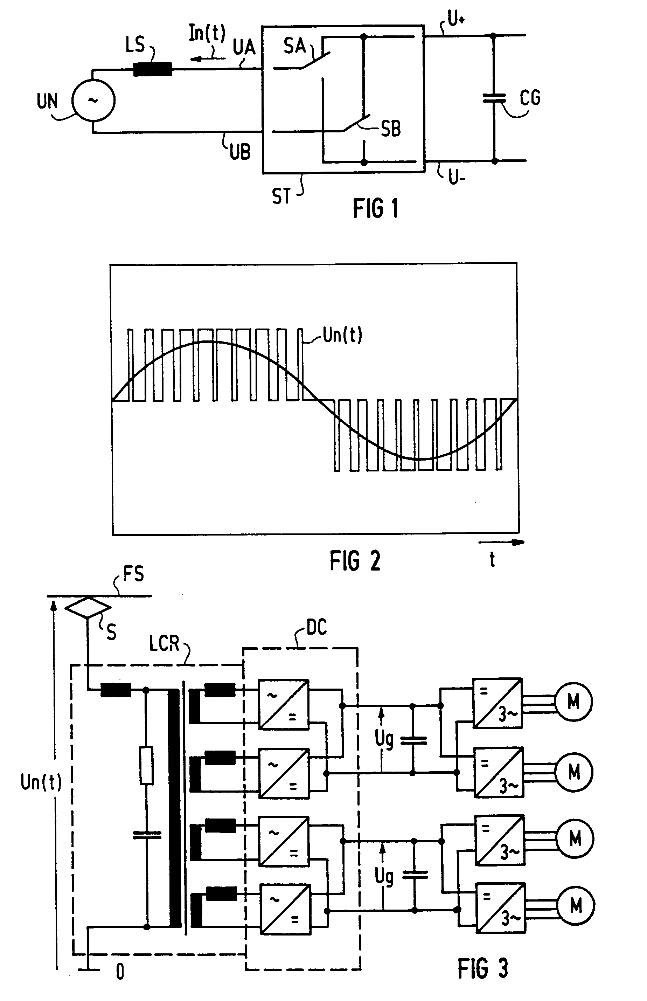

Zur Erläuterung des Problems ist in FIG 1 zunächst ein einphasiger Pulswechselrichter dargestellt, der als "Vierquadranten-Steller" bekannt ist und z.B. im Fall eines Zwischenkreisumrichters mit eingeprägter Gleichspannung an seinen Gleichspannungsanschlüssen auf den Potentialen U+ und U- liegt. Der Schalter SA des Stellers ST verbindet einen Wechselspannungsanschluß alternierend mit den beiden Gleichspannungsanschlüssen, so daß dort das Potential UA nur einen der beiden Werte U+ und U- annehmen kann.

Entsprechendes gilt für den anderen Schalter SB des Stellers und für dessen anderen Wechselspannungsanschluß, dessen Potential UB somit ebenfalls nur einen der beiden Werte U+ und U- annehmen kann. Dieser Wechselrichter besitzt daher an seinen wechselspannungsseitigen Anschlüssen die Anschlußspannung U = UA - UB. FIG 2 zeigt die Spannung U für den Fall, daß die Umschaltimpulse der Schalter durch Modulation einer sinusförmigen Steuerspannung mit einer höherfrequenten Sägezahnspannung gewonnen werden. Durch diese bekannte "Pulsbreitenmodulation" entstehen also eine Spannungsgrundschwingung und Oberschwingung die durch die Gleichspannung U+-U-und die Phasenlage der Umschaltimpulse gegeben sind.

In FIG 1 ist angenommen, daß der Steller über eine vorgeschaltete Steller-Drossel LS an das Versorgungsnetz UN mit der Versorgungsspannung Un(t) angeschlossen ist. Der Spannungsabfall Uls an der Drossel LS kann daher nur die Werte Uls = Un(t)±(U+ - U-) oder Uls = Un(t) (in diesem Fall sind beide Schalter entweder nur mit U+ oder nur mit U- verbunden) annehmen. Entsprechend der Induktivität Ls der Stellerdrossel gilt dann für den Strom In(t), der über die Stellerdrossel zwischen dem Netz und dem Steller ausgetauscht wird: d/dt In(t) = Uls/Ls.

Durch entsprechendes Betätigen der Schalter kann erreicht werden, daß dieser Strom jede beliebige Kurvenform zumindest näherungsweise annimmt. So kann z.B. gefordert werden, daß das Netz möglichst nur mit Wirkstrom belastet wird. An den wechselspannungsseitigen Stelleranschlüssen muß dann eine gepulste Spannung erzeugt werden, deren Grundschwingung gegenüber dem Netz eine Phasenverschiebung aufweist, die von dem Strom und der Induktivität Ls abhängt. Um die Sinusform des Stromes möglichst gut anzunähern, ist aber eine hohe Schaltfrequenz erforderlich, und die Spannungsgrundschwingung ist von vielen Oberschwingungen überlagert.

Diese Spannungsoberschwingungen erzeugen in der Induktivität LS und dem Netz hochfrequente Störströme und können im Netz vorhandene Impedanzen zu Resonanzen anregen.

Falls an die wechselspannungsseitigen Anschlüsse eine Last mit bekannter Impedanz, z.B. eine Drehfeldmaschine, angeschlossen ist, kann natürlich bei vorgegebener Gleichspannung durch den Stromrichter Frequenz und Amplitude des Laststromes eingestellt werden. Manche der dabei auftretenden Oberfrequenzen sind unkritisch, da sie durch die Innenbeschaltung der Last ausreichend gedämpft oder auch kompensiert werden. Andere Oberschwingungen jedoch sind kritisch, weil sie störende Oberschwingungen anderer Größen (z.B. des Drehmoments der angeschlossenen Maschine) hervorrufen. Um in diesem Fall nicht nur Frequenz, Amplitude und Phasenverschiebung für die Grundschwingung von Laststrom und Spannung zu beeinflussen, sondern auch die störenden Oberschwingungskomponenten zu minimisieren, sind bereits verschiedene Steuerverfahren vorgeschlagen worden.

So können z.B. einzelne Oberschwingungskomponenten vollständig eliminiert werden (H.S.Patel, R.F.Hoft: "Generalized Techniques of Harmonic Elimination and Voltage Control of Thyristor Inverters", IEEE Transactions on Industrial Applications, vol.IA-9 (1973), p.310 - 317 und vol.IA-10 (1974), p.666-673). Es kann auch der Effektivwert der Oberschwingungsströme minimiert werden (G.S.Buja, G.B.Indri: "Optimal Pulse-width Modulation for Feeding AC Motors", IEEE Transactions on Industrial Applications, vol.IA-13 (1977), p.38-44) oder es wird der Scheitelstrom des Wechselrichterstroms minimiert (J. Holtz, S. Stadtfeld, H.P. Wurm: "a Novel PWM Technique Minimizing the Peak Inverter Current at Steady-State and Transient Operation", Elektrische Bahnen, vol.81 (1983), p.55-61).

Die jeweils durchzuführenden Schaltvorgänge führen zu bestimmten "Pulsmustern" und sind gegeben durch die "Schaltwinkel", d.h. durch die Zeitpunkte innerhalb einer Periode der Grundschwingung, bei denen im Stromrichter die Schaltvorgänge vorgenommen werden sollen. Für die Optimierung wird in Abhängigkeit von diesen Schaltwinkeln eine "Ziel-Funktion" aufgestellt, d.h. eine Funktion, deren Wert die jeweils zu optimierende Größe (z.B. Amplitude einer bestimmten Oberschwingung oder Scheitelwert des Wechselrichterstroms) angibt. In einem mathematischen Algorithmus wird dann durch Optimierung der Variablen dieser Zielfunktion, z.B. also Variation der Schaltzeitpunkte, das Pulsmuster berechnet, bei dem die Zielfunktion ihren optimalen Wert annimmt. Diese Optimierungsrechnung ist im allgemeinen verhältnis-

2

mäßig aufwendig und wird nicht in Echtzeit ("on-line-Optimierung") sondern jeweils für einen Satz von Betriebsbedingungen, insbesondere für verschiedene Aussteuerungen und Leistungsgrade bei stationärem Betrieb des Wechselrichters, ausgeführt. Die sich jeweils ergebenden, optimierten Schaltwinkel werden dann als feste Pulsmuster im Speicherbereich eines Mikrorechners abgelegt ("off-line-Optimierung"). Im Echtzeitbetrieb wird dann unter den abgespeicherten Pulsmustern das zur gewünschten Aussteuerung gehörende Pulsmuster ausgelesen und zur Steuerung des Stromrichters verwendet. Derartig ausgeführte Steuerungen sind z.B. von J. Holtz, S. Stadtfeld im "An Economic Very High Power PWM Inverter for Induction Motor Drives", First European Conference on Power Electronics and Applications EPE", Brüssel (1985), Seite 3.75 - 3.80 und von J.A.Taufiq, B.Mellit und C.J. Goodman in "Novel Algorithm for Generating Near Optimal PWM Waveforms for A.C. Truction Drives", IEEE Proceedings, vol.133, part B (1986), p.85 - 94 beschrieben.

Ausgangspunkt für die Optimierung von Pulsmustern ist also die Festlegung eines Zieles, d.h. es muß formuliert werden, was durch die Optimierung erreicht werden soll. Bei der Speisung von Wechselstromlasten ergibt sich dieses Ziel aus den bekannten und im allgemeinen zeitunabhängigen Erfordernissen der Last. Die erwähnten Verfahren sind daher für die Steuerung des maschinenseitigen Pulswechselrichters eines Zwischenkreisumrichters diskutiert. Für den netzseitigen Gleichrichter besteht primär die Forderung, daß dem Netz ein möglichst sinusförmiger Strom entnommen werden soll, dessen Amplitude durch den erforderlichen Laststrom und dessen Phasenlage zur Netzspannung dadurch bestimmt ist, daß das Netz mit keiner oder nur einer definierten Blindlast belastet werden soll.

Wenn die Last nicht einfach aufgebaut ist, sondern z.B. auch Leitungen oder Schwingkreise mit ausgeprägten Eigenresonanz-Frequenzen enthält, so können die bei einer Steuerung nach FIG 2 auftretenden Oberschwingungen diese Eigenresonanzen anregen. Bei der Optimierung der Pulsmuster sollte dann von einer Zielfunktion ausgegangen werden, die auf die Dämpfung dieser Eigenresonanzen besonderes Gewicht legt. Dies setzt aber eine Kenntnis über die Konfiguration der angeschlossenen Last voraus, die bei ausgedehnten Energieverteilungsnetzen schwer zu erhalten ist.

Derartige schwingungsfähige Netzkonfigurationen liegen vor allem in den Versorgungsnetzen der Stromrichter vor, an denen eine oft unbekannte Zahl anderer Geräte mit zeitlich wechselnden Betriebszuständen angeschlossen sind.

Als bevorzugte Anwendung der Erfindung wird im folgenden der Antrieb einer Lokomotive der Baureihe 120 der Deutschen Bundesbahn betrachtet. Es handelt sich also um ein einphasiges Versorgungsnetz mit 16 2/3 Hz, an dem ein Steller angeschlossen ist zur Gleichstromeinspeisung in einen Zwischenkreis vorgegebener Gleichspannung, die über Wechselrichter mehrere Asynchronmotoren speist. Die Erfindung ist aber weder auf den einphasigen Fall noch auf den Gleichrichterbetrieb der speziell dargestellten Stromrichterschaltung beschränkt.

FIG 3 zeigt schematisch den Leistungsteil der Lokomotive, bei dem eine zwischen dem Fahrdraht FS der Oberleitung und einem Erdungsanschluß 0 liegende Netzspannung Un(t) von etwa 15 kV über einen Stromabnehmer S und ein Oberschwingungsfilter LCR einen Gleichstromsteller speist. Der Gleichstromsteller DC besteht dabei aus vier einzelnen Vier-Quadranten-Stellern, bei denen nach dem Prinzip des Wechselrichters aus FIG 1 jeweils einer der Wechselspannungsanschlüsse über zwei alternierend betätigte Schalter mit den Gleichspannungsanschlüssen verbunden wird.

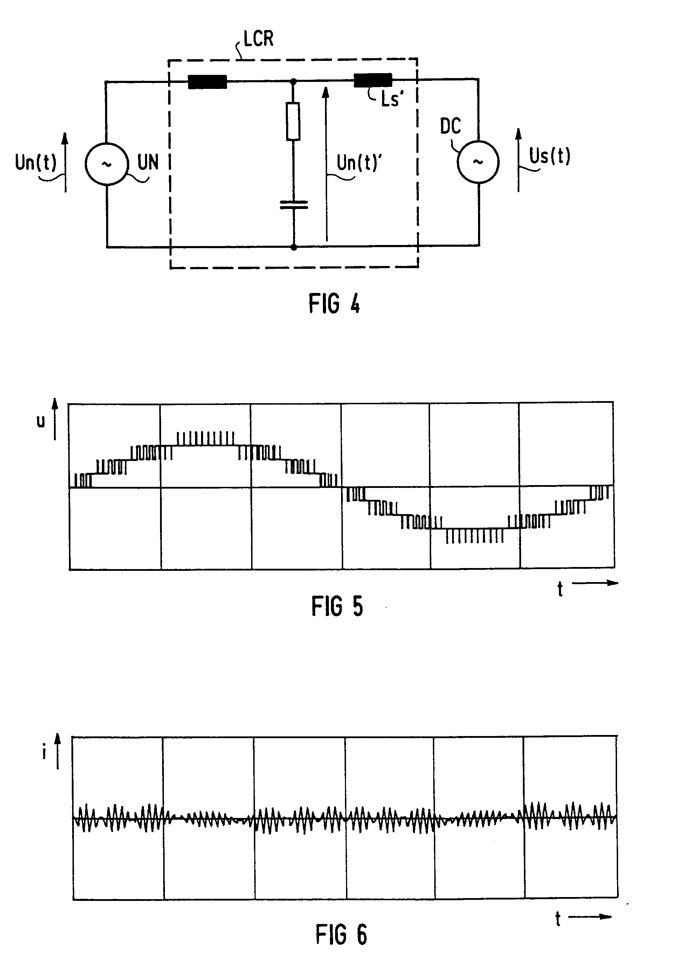

Die einzelnen Vier-Quadranten-Steller sind wechselspannungsseitig transformatorisch in Reihe an das Oberschwingungsfilter angeschlossen. An die Stelle des einzigen Potentials U+ in FIG 1 treten daher durch die additive Wirkung der parallel arbeitenden Einzel-Steller vier Potentiale, und das gleiche gilt für das Potential U−. In dem Ersatzschaltbild der FIG 4 sind die Streuinduktivitäten an den Wechselspannungsanschlüssen der Steller zu einer Steller-Ersatzdrossel Ls' zusammengefaßt, und für den Spannungsabfall Uls' an dieser Steller-Ersatzdrossel gilt dann:

$$Uls' = Un(t)' - Us(t)$$

wobei Un(t)' die sekundärseitige Transformatorspannung und Us eine Stellerersatzspannung ist, für die gilt:

$$Us(t) = k.Ug.$$

Die Variable k kann dabei die Werte -4, -3, ..., + 4 annehmen. Der jeweilige Wert ist zeitabhängig und durch die Ansteuerung der Schalter, also das Pulsmuster für den Betrieb der gesamten Stelleranordnung gegeben. Entsprechend kann Us(t) aus dem Wert Ug der Gleichspannung und dem Pulsmuster berechnet oder durch Addition der gemessenen Wechselspannungen der Einzel-Steller gebildet werden.

Der Verlauf der Spannung Us(t) ist in FIG 5 dargestellt. Er führt zu einem sinusförmigen Strom im Fahrdraht, der von Oberschwingungen überlagert ist, wie in FIG 6 gezeigt ist. Derartige Pulsmuster liegen auch bei anderen gepulsten Wechselrichtern mit einer eingeprägten Gleichspannung vor, z.B. bei Mehrpunkt-Wechselrichtern.

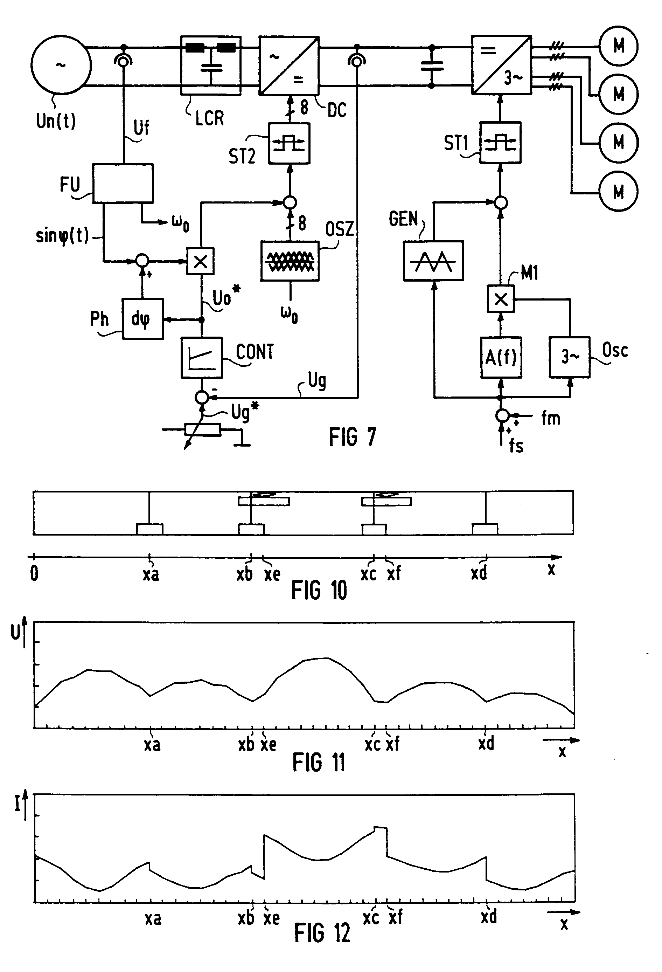

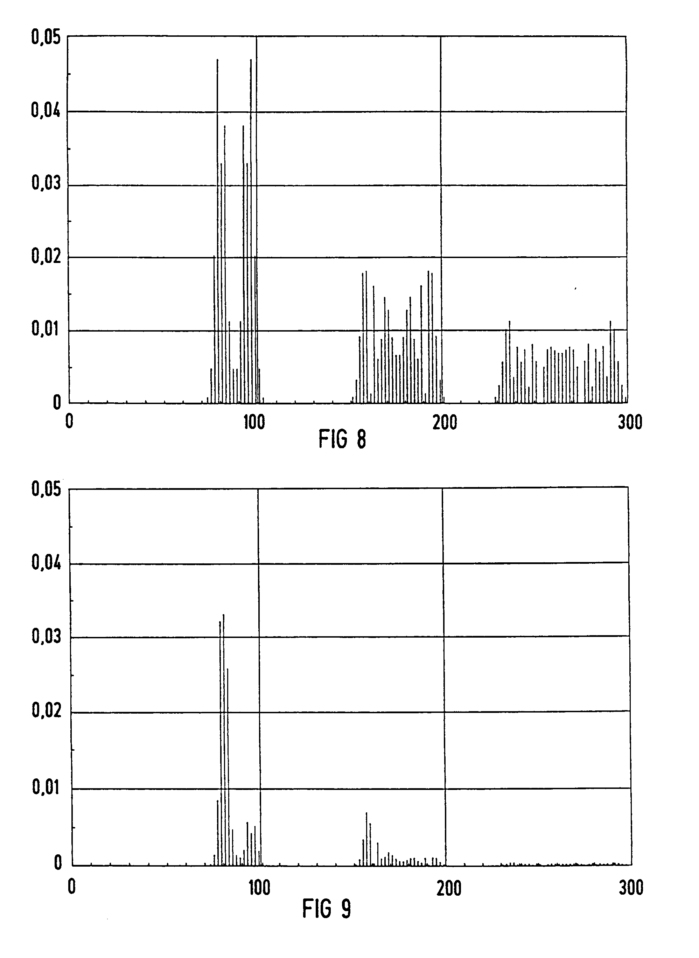

Das Pulsmuster, das der FIG 5 zugrunde liegt, ist bei dieser bekannten Lokomotive durch das "Unterschwingungsverfahren" erzeugt, bei dem ein Sollwert für die Wechselspannung mit einer synchronisierten höherfrequenten Sägezahn-Spannung moduliert wird. FIG 7 zeigt Einzelheiten der Steuerung für die bekannte Lokomotive ("Elektrische Bahnen" 47 (1976), S.18-23).

Dabei wird ein Schlupffrequenz-Sollwert fs proportional zum gewünschten Antriebsmoment vorgegeben, und aus der gemessenen mechanischen Drehzahl fm der Antriebsmotoren die Ständerfrequenz $f = fs + fm$ der Antriebsmotoren gebildet. Ein Kennlinien-Glied A(f) bildet daraus die Amplitude A, die im Multiplizierer M1 mit den Phasensignalen eines mit der Ständerfrequenz f gesteuerten Oszillators multipliziert wird, um daraus die gegeneinander phasenversetzten Sollwerte der drei Phasenspannungen der Antriebsmotoren M zu erhalten. Diese Phasenspannungen werden pulsbreitenmoduliert, indem aus den Schnittpunkten mit einer Sägezahnspannung, die in einem Generator GEN z.B. als Vielfaches der Ständerfrequenz f gebildet wird, in einem Steuersatz ST1 die Zündimpulse für die Ventile des motorseitigen Wechselrichters erzeugt werden.

Die Eingangsgleichspannung Ug dieses motorseitigen Wechselrichters wird durch die Steuerung des z.B. als Gleichrichter betriebenen einphasigen Pulswechselrichters DC über einen Spannungsregler CONT auf einem vorgegebenen Sollwert Ug* gehalten. Dazu wird am Netz (d.h. am Fahrdraht FS der FIG 3) die Netzspannung Un(t) abgegriffen, aus der in einer Filteranordnung FU die Frequenz $\omega_o$ und der Phasenwinkel $\gamma(t) = \omega_o.t$ der Grundschwingung gebildet wird. Eine Frequenzverschiebung, die von Filteranordnung und anderen Bauelementen hervorgerufen wird, kann durch einen entsprechenden Phasendifferenz-Sollwert $d\gamma$, der in Abhängigkeit von den am Spannungsregler abgegriffenen Amplituden-Sollwert $U_O^*$ der Spannungsgrundschwingung in einem Kennliniengied Ph gebildet wird, kompensiert werden. Der Multiplizierer M2 bildet entsprechend dem korrigierten Phasenwinkel $\gamma(t) + d\gamma$ einen Sollwert $U(t)^* = U_O^*.\sin(\gamma(t)+d\gamma)$ für die Spannungsgrundschwingung des Wechselrichters DC.

Dieser Sollwert U*(t) wird zur Steuerung des Pulswechselrichters DC verwendet.

Dazu werden vier auf die Frequenz $\omega_o$ abgestimmte, höherfrequente Sägezahnspannungen in einem Oszillator OSZ gebildet, die jeweils einem Einzel-Wechselrichter der FIG 3 zugeordnet sind. Ein Steuersatz ST2 bildet aus den Schnittpunkten des Sollwertes U*(t) mit einer Sägezahnkurve bzw. der invertierten Sägezahnkurve die Schaltzeitpunkte zum Betätigen des Umschalters SA bzw. SB (FIG 1) des zugeordneten Einzel-Wechselrichters.

Aufgabe des Oberschwingungsfilters LCR ist, das Netz und andere, daran angeschlossene Geräte von Oberschwingungen zu entlasten, und gleichzeitig auch den eigenen Stromrichter vor Oberschwingungen, die im Netz wegen der anderen Geräte vorhanden sein können, zu schützen. Für die Stellerersatzspannung Us(t) zeigt FIG 8 das Oberschwingungsspektrum, das durch Fourieranalyse aus FIG 5 entsteht, und FIG 9 das entsprechende Spektrum der Spannung Un(t) am netzseitigen Filteranschluß, d.h. am Fahrdraht.

Daraus wird deutlich, daß bei leistungsstarken Stromrichtern das speisende Netz nicht als derart starr angesehen werden kann, daß alle Oberschwingungen bereits vom Filter aufgenommen werden und die Netzspannung nicht mehr beeinflussen. Wie z.B. aus der Praxis bei Hochspannungsgleichstromübertragungen oder bei Bahnnetzen bekannt ist, vermögen derartige Rest-Oberschwingungen, wie sie in FIG 9 dargestellt sind, das Netz noch derart zu belasten, daß empfindliche Geräte gestört werden, vor allem datenverarbeitende Steuergeräte, Sicherheitseinrichtungen, Fernmelde- und Signalanlagen, die am oder in der Nähe des Netzes installiert sind. Derartige Probleme treten nicht nur beim Betrieb von Gleichrichtern an Wechselspannungsnetzen, sondern z.B. auch bei Gleichstromstellern an Gleichspannungsnetzen auf.

So ist z.B. in der deutschen Offenlegungsschrift 29 44 334 vorgeschlagen, im netzgespeisten Gleichstromsteller eines U-Bahn-Triebwagens von einer Stellerfrequenz auf eine andere Stellerfrequenz umzuschalten, wenn die vom Steller und dem nachfolgenden maschinenseitigen Wechselrichter des Triebwagens ins U-Bahn-Gleichstromnetz rückgespeiste Störspannung in einen Frequenzbereich gerät, der für die Sicherheitsanlagen der U-Bahn kritisch ist.

Es handelt sich also bei dieser Umschalteinrichtung um eine besonders einfache Art eines "Optimierungsrechners", der aus vorgegebenen, kritischen Frequenzbereichen derartige Steuersignale für den Steller abgibt, daß diese kritischen Frequenzen im Netz nicht angeregt werden. Als Optimierungskriterium dient in diesem Fall die minimale Anregung der kritischen Frequenzen, auf die das Netz und im Netzbereich installierte Geräte besonders empfindlich ist.

Es ist üblich, die Empfindlichkeit auf Oberschwingungen durch eine Empfindlichkeitsfunktion, den sogenannten "psophometrischen Faktor", zu beschreiben. Der ins Netz rückgespeiste Oberschwingungs-

EP 0 491 691 B1

strom des Stromrichters wird dann mit diesem Faktor gewichtet (psophometric weighting), um nachfolgend eine Auswertung zwischen kritischen und unkritischen Oberschwingungen durchführen zu können und geeignete, unkritische Pulsmuster auszuwählen.

Diesen durch diese Bewertung erhaltenen "psophometrischen Störstrom" z.B. im Stromabnehmer einer Lokomotive als Maß für die Störbeeinflussung durch den Stromrichter heranzuziehen, ist zwar üblich, jedoch unzureichend. Für die Störbeeinflussung tatsächlich maßgebend ist nämlich nicht der vom Stromrichter selbst eingespeiste Oberschwingungsstrom, bei einer Lokomotive also der Strom im Stromabnehmer, sondern der im Netz selbst auftretende Oberschwingungsstrom, d.h. der Strom im Fahrdraht. Außerdem ist nicht der Oberschwingungsstrom des Netzes am Ort seiner Einspeisung maßgebend, wo er im Fall eines Triebfahrzeuges schon aus praktischen Gründen nicht meßbar ist, sondern dieser Netz-Oberschwingungsstrom müßte an allen den Orten, an denen kritische Geräte vorhanden sind, gemessen und dem Stromrichter zur Bestimmung des optimalen Pulsmusters gemeldet werden. Die vom Stromrichter angeregten Oberschwingungen breiten sich im Netz nämlich entsprechend der jeweiligen Konfiguration des Netzes und der anderen, daran angeschlossenen Verbraucher aus und können an den verschiedenen Orten des Netzes zu ganz unterschiedlichen Resonanzerscheinungen führen. Daher wären häufig wesentlich größere Oberschwingungsströme am netzseitigen Stromrichteranschluß zulässig, falls in deren Spektrum die jeweils resonanzanregenden Komponenten fehlen würden. Umgekehrt kann ein vom Stromrichter eingespeister, relativ niedriger Oberschwingungsstrom in bestimmten Netzteilen zu erheblichen Stromresonanzen und Stromüberhöhungen führen.

Ist die Konfiguration des Netzes hinreichend genau bekannt, so kann dessen Verhalten durch Systeme partieller Differentialgleichungen beschrieben werden, wie dies z.B. von J.Holtz und H.-J.Klein beschrieben ist ("The propagation of harmonic currents generated by inverter-fed locomotives in the distributed overhead supply system" European Conference on Power Electronics and Applications, EPE Grenoble (1987), Seite 1239 - 1244).

FIG 10 zeigt eine Konfiguration, bei der an den Orten xa, xb, xc und xd entsprechende Unterwerke in einen Fahrdraht einspeisen und sich an den Orten xe und xf Triebfahrzeuge befinden, die über ihre Stromabnehmer an den Fahrdraht angeschlossen sind. Die Figuren 11 und 12 zeigen den Effektivwert der Oberschwingungen von Spannung und Strom längs des Fahrdrahtes.

Aus FIG 11 erkennt man, daß die von den Lokomotiven in den Fahrdraht eingespeiste Störspannung zu einem Störstrom führt, der sich über den Fahrdraht ausbreitet und nur teilweise über die nächste Anschlußstelle (Lokomotive oder Unterwerk) abfließt. Für die von diesem Teil des Störstromes angeregten Frequenzen wirken also die anderen Stromrichter des Netzes bereits als Dämpfung, was einen niedrigen Wechselstromwiderstand (Impedanz) des Netzes für den eingespeisten Störstrom dieser Frequenz bedeutet.

Ein Teil des Störstromes breitet sich aber über das ganze Netz aus und regt Strom und Spannung zu stehenden Wellen an, die nur von dem längs des ganzen Netzes verteilten Widerstand des Fahrdrahtes gedämpft werden können. Im Resonanzfall kann das Netz nicht mehr Energie aufnehmen, als im Fahrdraht selbst verbraucht wird, das Netz besitzt daher für diese Frequenzen ein Maximum der Impedanz.

Eine Reihenschaltung aus einem Widerstand R, einer Induktivität L und einer Kapazität C besitzt die Impedanz

$$Z = \sqrt{R^2 + (\omega L - 1/\omega C)^2}$$

die bei der Frequenz

$$\omega_i = \sqrt{\frac{1}{LC} - \frac{R^2}{4L^2}}$$

ein Minimum besitzt. Frequenzen, für die das Netz sich wie ein Reihenschwingkreis verhält, sind also für die Ausbreitung stehender Wellen unkritisch. Werden jedoch Induktivität und Kapazität parallel geschaltet, so besitzt die Impedanz für diese Frequenz ein Maximum ("Parallelschwingkreis"). Ein derartiges Verhalten des Netzes ist kritisch.

Die Ausbildung stehender Wellen und deren Frequenzen sind sowohl von der räumlichen Konfiguration des Netzes, insbesondere also auch dem Ort der jeweiligen Stromrichter, wie auch von den Betriebszuständen der Stromrichter selbst abhängig. Da sich diese Parameter aber zeitlich ständig verändern können, kann man von vornherein keine bestimmte, zeitlich konstante Frequenz angeben, auf deren Unterdrückung

5

EP 0 491 691 B1

das Pulsmuster eines Stromrichters ausgelegt werden müßte, um Resonanzen im Netz auszuschließen.

Kommt es infolge der Resonanzanregung zu lokalen Spannungsüberhöhungen, so müssen auch für Geräte, die keinen Frequenzbereich besitzen, in dem sie besonders oberschwingungsgefährdet sind, Störungen erwartet werden. Daß dies auftreten kann, ergibt sich aus Spannungsüberschlägen, die an elektrischen Einrichtungen im Bereich von Bahnnetzen bereits beim Betrieb von Triebfahrzeugen mit Pulsstromrichtern ohne vorgeschaltete Oberschwingungsfilter beobachtet worden sind. Durch die Installation eines entsprechendes Oberschwingungsfilters kann sich aber das Gewicht einer Lokomotive um nahezu eine Tonne erhöhen, was wiederum ungünstige Auswirkungen auf die räumliche und mechanische Konstruktion der Lokomotive hat.

Ferner ist es wünschenswert, daß auch Oberschwingungen niedriger Ordnungszahl nur schwach angeregt werden, da diese von einem Oberschwingungsfilter nicht gedämpft werden können. Derartige niederfrequente Oberschwingungen treten aber auch bei festen Impulsmustern, die an sich nur höhere Oberfrequenzen enthalten, immer dann auf, wenn in der Steuerung der Stromrichter Unsymmetrien vorliegen. Ferner kann es beim Betrieb von Fahrzeugen vorkommen, daß nur ein Drehgestell angetrieben und dann das eigene Oberschwingungsfilter abgeschaltet werden muß, um eine Überlastung zu vermeiden.

Aus FIG 11 erkennt man, daß selbst in entfernteren Netzabschnitten noch erhebliche Resonanzströme aufteten können. Befinden sich mehrere Triebfahrzeuge in einem gleichen oder benachbarten Netzabschnitt, so kommt es zu einer gegenseitigen Beeinflussung, bei der zwischen den beteiligten Fahrzeugen hohe Störströme ausgetauscht werden.

Diese Nachteile erzeugen den Wunsch, den Stromrichter so zu steuern, daß die Spektralkomponenten der von ihm in das ausgedehnte Versorgungsnetz eingespeisten Oberschwingungsströme nicht mit den Eigenfrequenzen des Netzes zusammenfallen. Dadurch kann erreicht werden, daß die Gefährdung von Anlagenteilen des Netzes durch Resonanzüberspannungen vermieden, die Störung von Signal- und Fernmeldesystemen im Netzbereich vermindert, die gegenseitige Beeinflussung von mehreren am gleichen Netz betriebenen Stromrichtern verhindert und die Baugröße von Oberschwingungsfiltern im Hochspannungsteil der Stromrichter verringert bzw. ein derartiges Filter überflüssig gemacht wird.

Um dies zu erreichen, könnten an sich die an das Netz angeschlossenen Ventile des Stromrichters nach einem Optimierungsverfahren gesteuert werden. Die für die Optimierung erforderliche Zielfunktion ist jedoch von der jeweiligen aktuellen Konfiguration des Netzes und der daran angeschlossenen Verbraucher abhängig und ändert sich ständig. Daher sind die erwähnten off-line-Verfahren der Optimierung nicht anwendbar.

Vielmehr ist eine Optimierung erforderlich, die an momentannen Resonanzeigenschaften des tatsächlichen Netzes angepaßt ist.

Aufgabe der vorliegenden Erfindung ist es also, bei einem ausgedehnten Versorgungsnetz, mit dem über einen Abgriff der netzseitige Anschluß eines Stromrichtergerätes verbunden ist, Meßgrößen zu bestimmen, die störende Resonanzen des Netzes erfassen und gestatten, verschiedene mögliche Pulsmuster des Stromrichtergerätes im Hinblick auf die Ausbildung der störenden Netzresonanzen zu bewerten. Insbesondere kann dann mittels dieser Meßgrößen eine geeignete Zielfunktion aufgestellt werden, aus deren Optimierung Pulsmuster gewonnen werden, die diese Netzresonanzen dämpfen oder zumindest möglichst wenig anregen.

Diese Aufgabe wird gelöst durch ein Verfahren mit den Merkmalen des Anspruchs 1.

Im tatsächlichen Netzwerk, an den der betrachtete Stromrichter angeschlossen ist, ist die Energie der angeregten Schwingungen über die ganze Leitung verteilt und die Amplituden von Oberschwingungsstrom und Oberschwingungsspannung sind von Ort zu Ort unterschiedlich. Es besteht also im realen Fall eine Ortsabhängigkeit dieser Größen. Die örtliche Verteilung ist sowohl von räumlich kontinuierlich verteilten Parametern, wie z.B. die komplexe Ausbreitungskonstante und der Wellenwiderstand der Leitung, bestimmt als auch von diskreten Parametern, wie den Induktivitäten in den Unterwerken.

Die Erfindung geht davon aus, daß für den Betrieb des Stromrichters diese Ortsabhängigkeit weitgehend ohne Bedeutung ist. Es genügt vielmehr, die frequenzabhängige Impedanz - d.h. wenigstens den Betrag, vorzugsweise aber den gesamten komplexen Wert der Impedanz des Netzes - am Einspeisepunkt des Stromrichters zu kennen. Diese Impedanz besitzt als Funktion der Frequenz Maxima, die auf Parallelresonanzen hinweisen und Minima, die Reihenresonanzen zugeordnet sind. Für den Betrieb des Stromrichters brauchen also die Kapazitäten und Induktivitäten in ihrer Abhängigkeit vom Ort und ihrer Verschaltung im tatsächlichen Netz nicht bekannt zu sein. Vielmehr genügt es, das Netz als ein Ersatzschaltbild ("virtuelles Modell") darzustellen, das aus einzelnen Resonanzkreisen aufgebaut ist, denen jeweils diskrete Werte für Kapazität, Induktivität und Widerstand zugeordnet sind.

Die im tatsächlichen Netz längs des Fahrdrahtes und seiner Abzweigungen verteilten Induktivitäten, Kapazitäten und Widerstände werden also zu diskreten Kapazitäten, Induktivitäten und Widerständen so

6

zusammengefaßt, daß ein Modell entsteht, das aus einzelnen Schwingkreisen besteht, denen diese diskreten Parameter zugeordnet werden.

Dadurch werden die Schwingungseigenschaften des Netzes auf die Resonanzen des Modells und die örtlich verteilten Parameter des Netzes auf die Parameter der Modellschwingkreise konzentriert.

Bei ausreichender Übereinstimmung der Impedanz des Netzes mit der Impedanz des Modells führen alle diejenigen Oberschwingungsströme des gepulsten Stromrichters, deren Spektralkomponenten in den Bereich einer Parallelresonanz des Modells (d.h. Maximum der Impedanz) fallen, dem Netz ständig Energie zu, die dort zu stehenden Wellen führt und gespeichert wird. Oberschwingungsströme, bei deren Frequenz die Modell-Impedanz ein Minimum hat, fließen aus dem Netz ab, hauptsächlich über Unterwerke oder andere Verbraucher. Für die Ausbreitung stehender Wellen beim Betrieb des Stromrichters sind daher die Parallelresonanz-Frequenzen kritisch und das Modell muß wenigstens die Frequenzen, in denen im tatsächlichen Netz parallelresonante Eigenschwingungen angeregt werden, ausreichend genau wiedergeben.

Eine bevorzugte Anwendung des Verfahrens ist im Anspruch 17 angegeben. Gemäß der Erfindung besitzt eine entsprechende Vorrichtung die in Anspruch 18 angegebenen Merkmale. Vorteilhafte Weiterbildungen sind in den Unteransprüchen angegeben.

Anhand von weiteren Figuren wird die Erfindung näher erläutert. Es zeigen:

| | |
|---|---|
| FIG 1 und 2 | einen bereits erläuterten Vierquadranten-Steller und seine Anschlußspannung Un(t) als erstes Beispiel eines Stromrichters, |
| FIG 3 und 4 | den bereits beschriebenen Leistungsteil eines Lokomotiven-Antriebs als bevorzugtes Beispiel eines Stromrichters und dessen Ersatzschaltbild, |
| FIG 5 und 6 | den bereits erläuterten Verlauf der Stromrichter-Anschlußspannung und des dabei auftretenden Oberschwingungsstroms, |
| FIG 7 | die bekannte Steuerung des Stromrichters, |
| FIG 8 und 9 | das Fourier-Spektrum der Spannung in FIG 5 und der dabei auftretenden Fahrdraht-spannung, |
| FIG 10 bis 12 | eine Fahrstrecke der in FIG 3 beschriebenen Lokomotive und die örtliche Amplitude der dabei auftretenden Oberwellen von Spannung und Strom, |
| FIG 13 und 14 | Ersatzschaltbilder zu FIG 3 unter Verwendung verschiedener Modelle, |
| FIG 15 | eine schematische Darstellung der Erfindung und ihrer Anwendung auf die Anordnung nach FIG 3, |
| FIG 16 | einen mit Rechenfehlern behafteten Quotienten von Fouriertransformierten, |
| FIG 17 und 18 | die beiden Fouriertransformierten für den Quotienten der FIG 16, |
| FIG 19 und 20 | ein Unterprogramm zur Bereinigung von Rechenfehlern und das entsprechend bereinigte Spektrum der FIG 16, |
| FIG 21 bis 23 | Unterprogramme zur Ermittlung der Resonanzfrequenz und Halbwertsbreite und deren Erläuterung, |
| FIG 24 und 25 | eine Impedanzfunktion mit einem Maximum und deren Darstellung durch einen Modell-Schwingkreis, |
| FIG 26 und 27 | eine Impedanzfunktion mit drei Maxima und eine darin enthaltene für eine Resonanzfrequenz isolierte Impedanzfunktion, |
| FIG 28 und 29 | zwei aus dem bereinigten Spektrum der FIG 20 gewonnene Spektren, die jeweils für eine Resonanzfrequenz isoliert wurden, |
| FIG 30 | die aus dem Netzmodell ermittelte und dem Impedanzspektrum der FIG 20 angenäherte Modell-Übertragungsfunktion, |
| FIG 31 und 33 | den on-line-berechneten Impedanzverlauf eines Netzes bei stochastischer Anregung und Anregung durch den Stromrichter einer Lokomotive, der die in FIG 32 dargestellte Oberschwingungsspannung erzeugt, |
| FIG 34 und 35 | die unter Anwendung der Erfindung optimierte wechselspannungsseitige Anschlußspannung des Stromrichters und den dabei auftretenden Störstrom, im Gegensatz zu FIG 5 und 6, |
| FIG 36 und 37 | die dabei im Gegensatz zu FIG 8 und 9 auftretenden Spannungsspektren, |
| FIG 38 und 39 | die dabei auftretende örtliche Verteilung der Amplituden von Spannung und Strom, |
| FIG 40 | den Reziprokwert des Impedanzbetrages, |
| FIG 41 | die komplexe reziproke Impedanz eines Schwingkreises, |
| FIG 42 | die Annäherung der Meßwerte durch Modellwerte eines Schwingkreises, und |
| FIG 43 und 44 | Meßergebnisse an einem Bahnnetz und deren Modellwerte. |

Gemäß der Erfindung werden also am Ort des Stromrichters, (genauer: Zwischen seinem netzseitigen Anschluß und dem Abgriff am Versorgungsnetz) zwei unterschiedliche elektrische Größen erfaßt. Diese Erfassung erfolgt fortlaufend - oder zumindest ununterbrochen während einer Periode einer vorgegebenen Grundfrequenz. Die eine elektrische Größe wird aufgefaßt als eine Anregung des Netzes, die vom Stromrichter und dessen Pulsmuster abhängig ist. Die andere elektrische Größe liefert dann Meßwerte für die im Netz angeregten Oberschwingungen.

In der Anmeldung "Vorrichtung und Verfahren zum optimierten Betrieb eines an ein Netz angeschlossenen Stromrichters" des gleichen Anmelders ist beschrieben, daß die gemäß der vorliegenden Erfindung gebildeten Meßgrößen und das ihnen zugrunde liegende Netzmodell verwendet werden können, um ein optimales Pulsmuster für den Betrieb des Stromrichters zu finden. Dabei wird der Zusammenhang zwischen der die Anregung des Netzes beschreibenden elektrischen Größe und dem Pulsmuster des Stromrichters ausgenutzt, um eine Zielfunktion aufzustellen und das Pulsmuster zu finden, bei dem der Wert der Zielfunktion ein bestimmtes Optimierungskriterium erfüllt.

Für die beiden elektrischen Größen wird gemäß der Erfindung die Übertragungsfunktion in Abhängigkeit von den in der anregenden Größe enthaltenen Frequenzen gebildet. Diese Übertragungsfunktion kann durch Fourier-Transformation beider Größen und anschließenden Division der Fourier-Transformierten gewonnen werden. Es sind aber auch andere Möglichkeiten durchführbar. Z.B. kann eine Funktion mit geschätzten Koeffizienten angesetzt werden, wobei die geschätzten Koeffizienten durch einen iterativen Algorithmus, der einem Vergleich errechneter Werte mit gemessenen Werten entspricht, korrigiert werden. Diese Funktion ist dann gleichwertig mit dem Quotienten der Fourier-transformierten Meßgrößen. Für jede Frequenz gibt dieser Quotient einen Meßwert für die Anregung des Netzes wieder.

An diese "gemessene" Übertragungsfunktion wird anschließend die Übertragungsfunktion eines virtuellen Modelles angenähert, das durch eine endliche Anzahl von Schwingkreisen dargestellt werden kann. Ein derartiger Schwingkreis besitzt jeweils einen Parameter-wert für seine Induktivität, Kapazität und Widerstand. In diesen Parametern sind dann die Resonanzeigenschaften des tatsächlichen Netzes konzentriert. Die Verschaltung dieser "konzentrierten" Elemente kann z.B. als Reihenschwingkreis oder als Parallelschwingkreis vorgenommen sein.

In die Übertragungsfunktion des Modells gehen die "konzentrierten" Elemente als Parameter ein, die durch die Annäherung an die aus den Meßwerten gewonnene tatsächliche Übertragungsfunktion praktisch meßbar werden. Diese Parameter geben daher die Resonanzeigenschaften des Netzes in einer geeigneten Form wieder und können als entsprechende Meßgrößen ausgegeben werden.

Das Netzmodell selbst braucht gar nicht in Hardware oder Software nachgebildet zu werden, vielmehr genügt es, daß die angenäherte Übertragungsfunktion lediglich der Übertragungsfunktion eines aus Schwingkreisen aufgebauten virtuellen Netzwerkes derart entspricht, daß der Übertragungsfunktion die charakteristischen Größen dieses virtuellen Modelles, insbesondere Anzahl, Frequenz, Halbwertsbreite und Dämpfung der Resonanzfrequenzen entnommen werden können. Diesen Größen entsprechen dann Anzahl, Widerstände, Kapazitäten und Impedanzen der Schwingkreise.

Die Fourier-Transformation der anregenden und der angeregten elektrischen Größe liefert Signale, die für jede Oberschwingung der Ordnung n die Oberschwingungsamplitude und die Phasenlage bestimmen.

Die Europäische Patentschrift 106 022 zeigt in FIG 9 eine an einem Netz angeschlossene Hardware-Schaltung, die letztlich als ein Bandpaßfilter mit einer Phase-locked-loop-Schaltung wirkt und für eine Grundschwingungsperiode, die für die Steuerung eines Stromrichtergerätes vorgegeben ist und am angeschlossenen Netz selbst bestimmt werden kann, die Amplitude und Phasenlage der Grundschwingung eines skalaren Meßwertes bestimmt.

Diese Schaltung kann also auch hier benutzt werden, um die Grundschwingungsperiode festzulegen und z.B. die Strom- oder Spannungsgrundwelle hinsichtlich Amplitude und Phasenlage zu bestimmen. Nach FIG 10 dieser Patentschrift kann dieses Meßverfahren auch für Drehstromsysteme angewendet werden, und es kann, wie die Europäische Patentschrift 97 958, FIG 5, 6 und 8 zeigt, für Ströme oder Spannungen eingesetzt werden, um für eine vorgegebene Ordnung k die entsprechende Oberschwingungsamplitude und -phase zu bestimmen.

Um z.B. Oberwellen bis zur Ordnung 300 zu erfassen, sind bei dieser Hardware-Lösung entsprechend vieler derartiger Schwingungsanalysen nötig. Im folgenden wird die Übertragungsfunktion in Software ermittelt und nur für Störgrößen betrachtet, die aus den ermittelten elektrischen Größen durch Subtraktion der entsprechenden Grundschwingung entstehen.

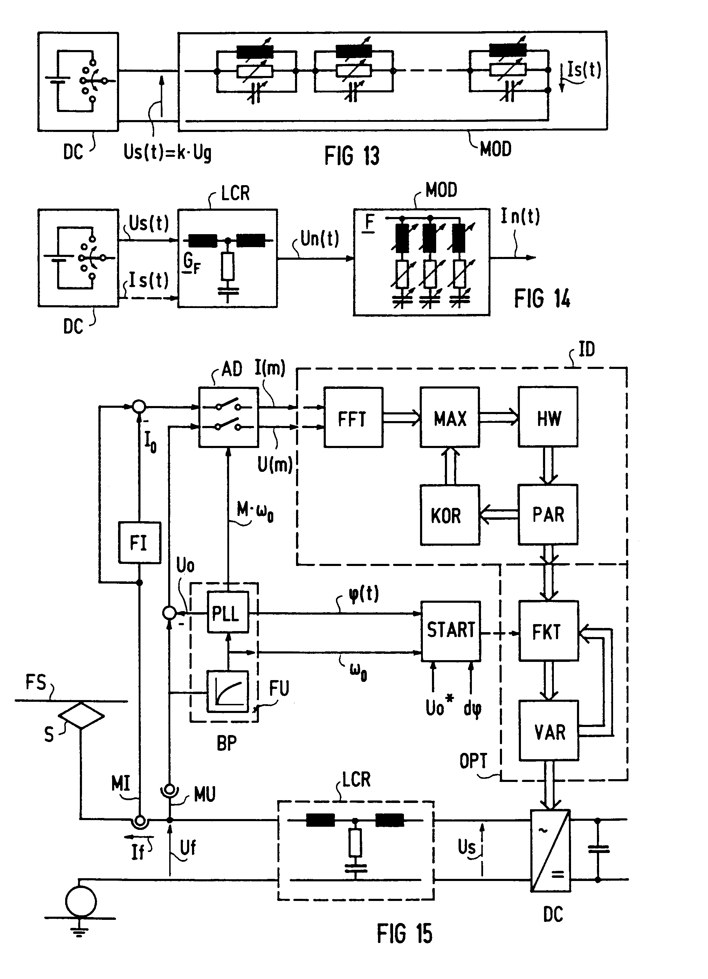

Als anregende und angeregte elektrische Größe können die Störspannung Us(t) und der Störstrom Is(t) direkt am Anschluß des Stromrichters verwendet werden (z.B. weil ein Oberschwingungsfilter zwischen dem Stromrichter und dem Anschluß des Netzes gar nicht vorhanden ist oder weil das Filter in die Betrachtung der Resonanzfrequenzen einbezogen werden soll). Betrachtet man nur die Eigenresonanzfrequenzen des Netzes, die als kritische Frequenzen ermittelt werden sollen, so ergibt sich für die Oberschwingungen von Strom und Spannung ein in FIG 13 gezeigtes geeignetes Ersatzschaltbild. Jede kritische Resonanzfrequenz entspricht dabei der Resonanz eines Reihenschwingkreises.

Der als Stromrichter betrachtete Steller DC ist dabei nach Art eines Mehrpunkt-Wechselrichters als eine Gleichspannungsquelle mit stufenweise einstellbarer Ausgangsspannung $U_s(t)$ dargestellt. Die Spannung ergibt sich dabei durch die Ansteuerung der Stromrichterventile und kann daher aus dem Pulsmuster und der eingeprägten Gleichspannung des Stellers berechnet werden. Anstelle einer derartigen errechneten Stellerersatzspannung kann aber auch die Anschlußspannung selbst gemessen werden.

Die Fouriertransformation der erfaßten zeitabhängigen Werte von Strom und Spannung liefert jeweils komplexe Zahlen $\underline{Is}(\omega_n)$ und $\underline{Us}(\omega_n)$ zur Darstellung der Oberschwingung mit der Frequenz $\omega_n$. Für die vom Steller erzeugten Oberschwingungen stellt das anschlußseitige Netzwerk ein schwingungsfähiges Gebilde dar, dessen Übertragungsfunktion

$$\underline{Z}(\omega_n) = \frac{\hat{U}s(\omega_n) \cdot \exp\left(j(\omega_n \cdot t - \varphi_u)\right)}{\hat{I}s(\omega_n) \cdot \exp\left(j(\omega_n \cdot t - \varphi_i)\right)} = \frac{\underline{U}s(\omega_n)}{\underline{I}s(\omega_n)}$$

für jede Oberschwingungsfrequenz $\omega_n$ sowohl das Verhältnis der Scheitelwerte $\hat{I}s(\omega_n)$ und $\hat{U}s(\omega_n)$ von Oberschwingungs-Strom und -Spannung, wie auch deren relative Phasenverschiebung angibt. Daher ist $\underline{Z}(\omega_n)$ eine komplexe Funktion der Frequenz $\omega_n$, die die spektrale Verteilung der Impedanz darstellt. Deren Betrag hat Maxima bei Frequenzen, bei denen eine Parallelresonanz im Netzwerk auftritt.

Bezüglich dieser Resonanzfrequenzen kann also die unbekannte Konfiguration des Netzes durch ein virtuelles Modell Mod nach FIG 3 ersetzt werden, dessen Übertragungsfunktion im Bereich der Impedanzmaxima hinreichend genau auf die gemessene Übertragungsfunktion $Z(\omega_n)$ abgeglichen werden kann.

In FIG 13 tritt immer dann ein Impedanzmaximum auf, wenn einer der hintereinander geschalteten Parallelschwingkreise in Resonanz gerät und daher die Stromrichter-Anschlußspannung $U_s(t)$ im wesentlichen an diesem Schwingkreis abfällt. Sollen also im tatsächlichen Netz keine Parallelresonanzen auftreten, so sollte ein optimales Pulsmuster gesucht werden, dessen Frequenzspektrum keine Frequenzen enthält, die im Resonanzfrequenz-Bereich eines der Schwingkreise des Netzmodells liegen.

Die Anzahl der Maxima in der tatsächlichen ("gemessenen") Übertragungsfunktion ergibt daher die Zahl der für das Netzmodell erforderlichen Schwingkreise. Frequenz, Amplitude und Halbwertsbreite bestimmen dabei die konzentrierten Parameter des Modells und beschreiben gleichzeitig das Resonanzverhalten des Netzes. Sie können daher als Meßgrößen der gemessenen Übertragungsfunktion entnommen und in einer geeigneten Zielfunktion für die Optimierung verwendet werden.

Ist an das Netz z.B. ein Wechselrichter mit vorgegebenem Eingangsgleichstrom angeschlossen, dessen Pulsmuster daher den Oberschwingungsstrom $I_s(t)$ einprägt, so kann als Kriterium für die Optimierung des Pulsmusters gefordert werden, daß die Summe der Spannungsabfälle an den Ersatzschwingkreisen - summiert über alle Stromoberschwingungen des Pulsmusters - minimal ist.

Da im Fall der Parallelresonanz in den Elementen des resonanten Schwingkreises hohe Ströme fließen, die den von außen eingespeisten Strom erheblich überschreiten können, kann als Zielfunktion einer Optimierung auch die Summe dieser Schwingkreisströme oder die von den Schwingkreisen aufgenommene Energie verwendet werden. Die Optimierung liefert dann ein Pulsmuster, bei dem der Wert dieser Zielfunktion optimal, also z.B. die Stromsumme oder die aufgenommene Energie minimal ist.

Auf diese Weise kann der Stromrichter betrieben werden, ohne im Netz wesentliche Parallelresonanzen anzuregen.

Bekanntlich kann eine Reihenschaltung von Impedanzen in eine äquivalente Parallelschaltung überführt werden, wobei sich die Dimensionierung der Impedanzelemente ändert. FIG 14 zeigt ein Ersatzschaltbild zu FIG 3, bei dem das Netz durch eine Parallelschaltung von Reihenschwingkreisen dargestellt ist. Eine derartige Darstellung ist vor allem für spannungseinprägende Stromrichter vorteilhaft, da die Netzspannung $U_n(t)$ dabei an allen Reihenschwingkreisen gleichermaßen anliegt und die Aufstellung einer von dem Pulsmuster abhängigen Zielfunktion (z.B. die Berechnung der oben erwähnten Stromsumme oder der aufgenommenen Energie) erleichtert.

In diesem Fall kann wieder für jeden Reihenschwingkreis des Modells die Dimensionierung der konzentrierten Elemente aus einem zugehörigen Maximum der Übertragungsfunktion entnommen werden. Als Übertragungsfunktion wird am einfachsten in diesem Fall die Leitwertfunktion

$$\underline{F}(\omega_n) = \frac{\underline{I}n(\omega_n)}{\underline{U}n(\omega_n)}$$

ermittelt. In FIG 14 sind dabei Strom und Spannung am Abgriff des Netzes die beiden elektrischen Größen, aus deren Meßwerten $I_n(t)$ und $U_n(t)$ durch Fouriertransformation die Größen $\underline{I}_n(\omega_n)$ und $\underline{U}_n(\omega_n)$ zur Bestimmung von $\underline{F}(\omega_n)$ gebildet werden können.

Tritt also bei der Frequenz $\omega_n = \omega_i$ ein Maximum in der Impedanz $Z(\omega_n)$ bei FIG.13 bzw. im Leitwert F-$(\omega_n)$ bei FIG 14 auf, so ist ein Resonanzkreis angeregt, dessen konzentrierte Parameter gegeben sind durch den Maximalwert $Z(\omega_i)$ bzw. $F(\omega_i)$ und die Bandbreite $\Delta\omega_i$ gemäß den bekannten Beziehungen:

$$R_i = Z(\omega_i) \; \text{bzw.} \; l/F(\omega_i)$$

$$L_i = Z(\omega_i) \cdot \Delta\omega_i/\omega_i^2 \; \text{bzw.} \; 1/(\Delta\omega_i \cdot F(\omega_i))$$
$$C_i = 1/(\omega_i \cdot Z(\omega_i)) \; \text{bzw.} \; F(\omega_i) \cdot \Delta\omega_i/\omega_i^2.$$

Ist ein Filter RCL zwischen dem Stromrichteranschluß und dem Abgriff am Netz vorhanden, so genügt es, zum Bestimmen der Übertragungsfunktion von den Größen $U_s(t)$, $I_s(t)$, $U_n(t)$ und $I_n(t)$, die an den Enden des Filters auftreten, irgendein Paar dieser Größen auszuwählen, da zwischen diesen Größen physikalische Beziehungen bestehen, die aus den bekannten Elementen des Filters errechnet werden können. Da die Resonanzen des Netzes in den entsprechenden Frequenzbereichen den Verlauf dieser Übertragungsfunktion bestimmen, können die entscheidenden Schwingkreisparameter auch den anderen Übertragungsfunktionen entnommen werden.

So kann z.B. die Spannung $U_s(t)$ am Stromrichteranschluß und die Spannung $U_n(t)$ am Netzanschluß (bei Lokomotiven: die Fahrdraht-Spannung) gemessen werden. Bei einem Impedanzmaximum im Netz tritt auch in der entsprechenden Übertragungsfunktion

$$\underline{G}(\omega_n) = \frac{\underline{U}n(\omega_n)}{\underline{U}s(\omega_n)}$$

nur ein entsprechend schwach gedämpftes Maximum auf, und umgekehrt entspricht eine starke Dämpfung bei einem Minimum der Netzimpedanz einer entsprechend stark gedämpften Oberschwingung im Spektrum $\underline{G}(\omega_n)$. Auch die vom Stromrichter durch sein Pulsmuster eingeprägte elektrische Größe (z.B. die Spannung $U_s(t)$ eines spannungseinprägenden Umrichters) ist aus dem Pulsmuster und anderen Betriebsparametern des Stromrichters (z.B. der Anschlußgleichspannung) berechenbar. Unter Umständen kann daher z.B. auf eine eigene Messung der Größe $\underline{U}s(t)$ verzichtet werden und statt dessen für $Us(\omega_n)$ eine mathematische Bestimmung vorgenommen werden.

FIG 15 zeigt die Anwendung des erfindungsgemäßen Verfahrens bei der Steuerung der betrachteten Lokomotive. An den Fahrdraht FS ist über den Stromabnehmer S und das Oberschwingungsfilter LCR der eine Pol des Stromrichters DC angeschlossen, dessen anderer Pol über die Räder geerdet ist. Der über den Stromabnehmer mit dem Netz (Fahrdraht FS) ausgetauschte Strom ist von einem Strommeßglied MI abgegriffen, um mittels eines Filters FI zur Subtraktion der Stromgrundschwingung IO den Störstrom If zu ermitteln. Auch für die Ermittlung der Störspannung Uf ist ein entsprechendes Spannungsmeßglied MU und ein Filter FU vorgesehen.

Dabei ist mit unterbrochenen Linien angedeutet, daß im Fall eines vorhandenen Filters LCR vorzugsweise das auf die Stromrichter-Anschlußspannung Us(t) wirkende System im Modell virtuell erfaßt wird.

Um den zeitlichen Verlauf des Oberschwingungsstroms und Oberschwingungsspannung während einer Periode der Grundschwingung zu ermitteln, werden diese Größen mittels eines Analog/Digital-Umsetzers AD in regelmäßig kurzen Zeitabständen $\tau$ abgetastet und einem Identifikationsrechner ID zugeführt. Wegen der sich ständig ändernden Konfiguration des Netzes muß diese Abtastung ständig wiederholt werden.

Das Spannungsfilter FU enthält daher neben einem Bandpaß BP eine "phase-locked-loop"-Schaltung PLL und liefert neben dem Phasensignal $\gamma$(t) und der Grundschwingungsamplitude UO die Grundfrequenz $\omega$O, die in einem Abtasttakt M . $\omega_o$ umgesetzt wird. Ist M = 1024 gewählt, so besteht zwischen der Grundschwingungsperiode TO der Netzspannung und der Abtastzeit $\tau$ des Analog/Digital-Umsetzers AD der Zusammenhang TO = M.$\tau$ und die Störgrößen werden zu den Zeitpunkten $t_m$ = m . $\tau$ mit m = O, I,..., M - I innerhalb der Grundschwingungsperiode abgetastet.

Dem Identifikationsrechner ID werden also anstelle kontinuierlicher Eingangsgrößen die diskreten, digitalen Werte I(m) und U(m) zugeführt, die jeweils für die Abtastperiode konstant gehalten sind. Entsprechend kann der Identifikationsrechner nur Werte berechnen, die für die diskreten Oberschwingungen $\omega_n$ = n . $\omega$O = n . 2 $\pi$/TO = n . 2 $\pi$/M . $\tau$ mit den Werten der tatsächlichen Übertragungsfunktion übereinstimmen. Sollen daher genügend viele Oberfrequenzen erfaßt werden, so muß M entsprechend groß gewählt werden.

Üblicherweise ermittelt eine Steuer- und Regeleinrichtung, mit welchen Sollwerten der Stromrichter betrieben werden soll, um in der angeschlossenen Last bestimmte Betriebsbedingungen aufrechtzuerhalten. Z.B. kann der Amplituden-Sollwert UO* sowie eine bestimmte Phasenverschiebung d$\gamma$ gegenüber der Netzspannung vorgegeben werden, um einzustellen, mit welcher Wirkleistung und Blindleistung das Netz vom Stromrichter beaufschlagt wird. Aus diesen Sollwerten folgen dann erste Startwerte für die Schaltwinkel des Umrichters. Diese werden z.B. beim Unterschwingungsverfahren dadurch gebildet, daß eine sinusförmige Grundschwingung mit Frequenz $\omega_o$, der Amplitude UO* und der Phasenverschiebung d$\gamma$ durch eine höherfrequente Sägezahnspannung moduliert wird. Die dadurch erhaltenen Zündwinkel sind jedoch noch nicht auf die Anregung von Resonanzschwin-gungen optimiert. Eine derart arbeitende Vorrichtung "START" liefert also nur die Zündwinkel für einen noch nicht optimierten Betrieb, die aber als Startwerte für eine Optimierung der Pulsmuster dienen können.

Der Optimierungsrechner OPT stellt nun sicher, daß die Pulsmuster, mit denen der Stromrichter DC tatsächlich angesteuert wird, keine Oberschwingungen in kritischen Frequenzbändern anregen. Diese kritischen Frequenzbänder werden durch Meßgrößen (z.B. die Resonanzfrequenzen $\omega_i$ und deren Halbwertsbreiten $\Delta\omega_i$ des Netzes) bestimmt, die vom Identifikationsrechner ID geliefert werden.

In besonders einfachen Fällen, in denen das von der üblichen Steuereinrichtung START gebildete Pulsmuster nur für wenige Oberschwingungen eine nennenswerte Anregung darstellt und auch für das Netz nur bestimmte Frequenzbänder kritisch werden können, kann es genügen, wenn der Optimierungsrechner lediglich das von START vorgegebene Pulsmuster daraufhin überprüft, ob es Frequenzen in den kritischen Frequenzbändern enthält, und ggf. auf ein anderes Impulsmuster umschaltet. Voraussetzung ist hierbei, daß von vornherein (z.B. durch eine vorangegangene off-line-Optimierung) eine ausreichende Auswahl an unterschiedlichen Pulsmustern vorgegeben werden kann.

In vielen Fällen kann jedoch die Konfiguration des Netzes derart variieren, daß es schwierig wird, in einer off-line-Optimierung geeignete Pulsmuster festzulegen, zwischen denen dann der Optimierungsrechner OPT nur auszuwählen hätte. In diesen Fällen ist es günstiger, wenn ein Funktionsrechenteil FKT jeweils zu einem Pulsmuster den Wert einer Zielfunktion (z.B. die in den Schwingkreisen gespeicherte Energie bei einem mathematisch nachgebildeten Betriebszustand, bei dem der Stromrichter die im virtuellen Modell des Netzes darstellbaren Schwingkreise mit-tels dieses Pulsmusters speisen würde) errechnet und das Pulsmuster im Variationsrechenteil VAR variiert, mit dem variierten Pulsmuster erneut den Wert der Zielfunktion errechnet, bis nach einigen Iterationen das optimale Pulsmuster gefunden ist, bei dem die Zielfunktion ein vorgegebenes Optimierungskriterium erfüllt. So kann z.B. das Pulsmuster gefunden werden, bei dem die gespeicherte Energie ein Minimum aufweist.

Die zu diesem optimalen Pulsmuster gehörenden Zündwinkel bestimmen dann Schaltwinkel. Sobald also der Phasenwinkel $\gamma$(t) der Spannungsgrundschwingung den auf diese Weise optimierten Wert eines Schaltwinkels erreicht, wird dem Steller ein entsprechender Umschaltbefehl gegeben.

Aus den Parametern der Schwingkreise muß aber die Zielfunktion selbst gar nicht direkt berechnet werden. Vielmehr genügt es, wenn mittels der Parameter für die einzelnen Schaltzeitpunkte lediglich berechnet wird, ob sich die Zielfunktion bei einer Variation des jeweiligen Schaltzeitpunktes verbessert oder verschlechtert. Auch dadurch wird es möglich, die einzelnen Schaltzeitpunkte solang zu variieren, bis die Zielfunktion ihren optimalen Wert annimmt.

Weitere Einzelheiten der jeweiligen Optimierungsrechnung sind in der gleichzeitig eingereichten Patentanmeldung des gleichen Anmelders "Verfahren und Vorrichtung zum optimierten Betrieb eines an ein Netz angeschlossenen Stromrichters" beschrieben.

Um im Identifikationsrechner zu den Zeitpunkten t = m . $\tau$ aus den abgetasteten Werten der beiden elektrischen Größen, z.B. U(m) und I(m) das Übertragungsverhalten zu bestimmen, können analytische Verfahren der Prozeßrechentechnik angewendet werden. Man kann auch einen instationären Zustand so

EP 0 491 691 B1

behandeln, als ob die innerhalb einer Periode abgetasteten Istwerte sich in den weiteren Perioden ständig wiederholen. Das Netz wird dann als ein lineares zeitinvariante diskretes System betrachtet, für das die in der Prozeßrechentechnik übliche z-Transformation vorgenommen werden kann. Für die entsprechende z-Übertragungsfunktion kann der Quotient zweier Polynome angesetzt werden, dessen Parameter mit Methoden der Modelladaption und Parameterschätzung ermittelt werden können.

Eine geeignete Methode ist die RIV-Methode der Hilfsvariablen, wie sie z.B. von A.Isermann in "Digitale Regelsysteme", Berlin 1977, bzw. "digital control systems" 1981 beschrieben ist. Dabei werden für die Koeffizienten dieser Polynome Schätzwerte eingesetzt, und jeweils nach der Abtastung eines Wertes für I-(m) und U(m) wird ein Algorithmus durchlaufen, der bei einer Anzahl N von Parametern jeweils N abgetastete Wertepaare verarbeitet und die Parameter des Modells korrigiert.

Die dabei ermittelten Koeffizienten geben dann die vollständige z-Übertragungsfunktion an, aber noch nicht die Anzahl und Dimensionierung der Schwingkreise, die für das Netzmodell erforderlich sind. Hierzu muß vielmehr erst die Variable z durch exp (-jω) substituiert werden, wodurch der Frequenzgang des Systems, also letztlich der Quotient der Fouriertransformierten Störfunktionen ermittelt wird.

Da sich diese Übertragungsfunktion auch hinsichtlich der Anzahl und Form ihrer Maxima ständig ändert, muß von vornherein eine ausreichend hohe Ordnung der Polynome (d.h. entsprechend viele Koeffizienten) angesetzt werden. Dadurch verlangsamt sich das Rechenverfahren erheblich. Dieses Verfahren ist daher wegen der verfügbaren Rechenzeit nur für einfache Netzkonfigurationen anwendbar. In diesen Fällen ist allerdings vorteilhaft, daß bereits eine stetige und verhältnismäßig glatte Übertragungsfunktion ermittelt wird.

Vorteilhaft wird mit den heute verfügbaren Rechnern jedoch eine direkte Fourier-Transformation der Störfunktionen vorgenommen. Dies geschieht nach der bekannten Methode der "Fast Fourier Transformation", wie sie im Programmteil FFT des Identifikationsrechners der Fig. 15 abläuft. Zur Einsparung an Rechenzeit und Speicherplätzen werden die beiden zeitabhängigen Störfunktionen gleichzeitig transformiert.

Die Fouriertransformierte einer reellen Zeitfunktion ist eine komplexe Funktion, deren Realteil durch eine gerade Funktion gebildet wird, während deren Imaginärteil eine ungerade Funktion ist. Man kann aber eine reelle Zeitfunktion in eine rein imaginäre Zeitfunktion überführen, deren Fouriertransformierte sich dann gerade umgekehrt verhält: Der Realteil ist eine ungerade Funktion, der Imaginärteil eine gerade Funktion. Daher kann aus der reellen Störfunktion U(m) und der reellen Zeitfunktion I(m) eine komplexe Zeitfunktion

$$\underline{F}(m) = U(m) + j . I(m)$$

synthetisiert werden, die keiner natürlichen Zeitfunktion zugeordnet werden kann und auch nicht die Symmetrieeigenschaften der Fouriertransformierten solcher Zeitfunktionen besitzt.

Mittels der Symmetrieeigenschaften der reellen Zeitfunktionen U(m) und I(m) kann aber diese synthetische Funktion $\underline{F}(m)$ in die komplexen Fouriertransformierten der beiden reellen Störfunktionen zurückzerlegt werden. Bezeichnet man mit Re(n) den Realteil und mit Im(n) den Imaginärteil der Fouriertransformierten $\underline{F}(n.\omega_o)$ der Funktion $\underline{F}(m)$ für die Frequenz n.ωO, so erhält man für die Fouriertransformierte $\underline{U}$-(n.ωO) der Spannung die Fouriertransformierte

$$(Re(n) + Re(M-n))/2 + j(Im(n) - Im(N-n)) = REF(n.\omega O)$$

wobei M wieder gemäß M.τ = TO durch die Abtastperiode des Analog/Digital-Umsetzers AD bestimmt ist. Entsprechend ergibt sich für die Fouriertransformierte $\underline{I}$(n.ωO) die Fouriertransformierte

$$(Im(n) + Im(M-n))/2 - j(Re(n) - Re(M-n))/2 = ANF(n.\omega O).$$

Der Betrag dieser Funktionen ist

$$ANB(n.\omega O) = \sqrt{(Re(n) - Re(M-n))^2 + (Im(n) + Im(M-n))^2}$$
$$REB(n.\omega O) = \sqrt{(Re(n) + Re(M-n))^2 + (Im(n) - Im(M-n))^2}.$$

Werden also zu den Abtastzeiten t = m.τ die Funktionswerte $\underline{F}(m.\tau)$ dieser synthetischen komplexen Zeitfunktion gebildet, so führt für die Oberfrequenz der Ordnung n (also die Frequenz n.ωO = n/M.ω_o) die Fouriertransformation zum komplexen Fourierkoeffizient

$$\underline{F}(n/M.\tau) = \underline{F}(m.\tau) . exp(-j2\pi .n.m/M) = \underline{w} . \underline{f}.$$

12

EP 0 491 691 B1

Die Fourierkoeffizienten für die Oberschwingung der Ordnung n ergeben sich also, wenn der M-dimensionale Meßvektor $\underline{f} = \{F(m\tau)\}$ mit der MxM-dimensionalen Matrix $\underline{w} = \exp(-j2\omega n.m/M)$ multipliziert wird. Hierzu sind also $M.\bar{M}$ komplexe Multiplikationen und (M-l).(M-l) komplexe Additionen erforderlich.

Der Rechenaufwand kann nach der bekannten Methode der "Fast-Fourier-Transformation" (FFT) verringert werden, bei dem die Matrix in geeignete, nur noch schwach besetzte Teilmatritzen zerlegt wird. Die FFT ist z.B. von Brigham und E. Oran in "FFT: Schnelle Fourier-Transformation", München 1985, beschrieben und ein besonders geeigneter Algorithmus ist der "Cooley-Tukey-Radix-2", der z.B. von C.S.Burrus in "DFT/FFT and Convolution Algorithms (Topics in Digital Signal Processing)", New York 1985, insbesondere Seite 108, beschrieben ist.

Für die Berechnung der Übertragungsfunktion sollen Frequenzen bis zur 300. Oberschwingung betrachtet werden. Die Fouriertransformation benötigt wegen ihres periodischen Spektrums zur Berechnung von M Oberschwingungen auch 2M Abtastwerte, also mindestens 600 Abtastwerte während einer Grundperiode. Die FFT setzt jedoch voraus, daß die Anzahl der Abtastwerte eine Potenz von 2 ist. Das ist durch die Abtastung mit $2^{10} = 1024$ Abtastwerten sichergestellt.

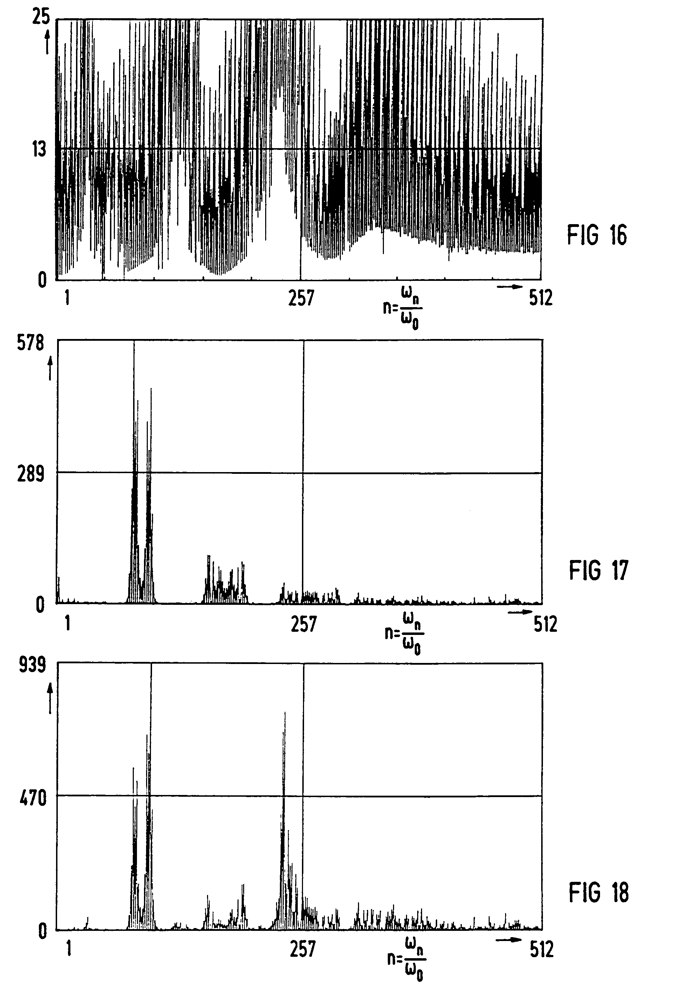

FIG 16 zeigt den Verlauf der Funktion

$Z(n.\omega O) = REB(n.\omega O)/ANB(n.\omega O)$, wobei der Maximalwert dieses Quotienten durch die Rechenkapazität des Rechners begrenzt ist. Hierbei treten starke Amplitudenabweichungen zwischen benachbarten Frequenzen auf. Diese sind auf numerisch bedingte Fehler zurückzuführen, die dadurch entstehen, daß der Quotient zweier sehr kleiner Zahlen gebildet wird. FIG 17 und FIG 18 zeigen jeweils den Betrag der Fouriertransformierten der Funktionen, wobei im Spektrum der erregenden Funktion (FIG 17) z.B. alle ungeraden Oberwellen verschwinden und daher auch im Spektrum der angeregten Funktion (FIG 18) nicht auftreten können. Der Quotient der entsprechenden, verschwindenden Spektralkomponenten ist also unbestimmt, durch Rundungsfehler bei der FFT werden jedoch die Amplituden nicht exakt Null, so daß nach der Division starke Unstetigkeitsstellen auftreten.

Um derartige Scheinwerte zu eliminieren, werden Frequenzen, bei denen im Spektrum der Erregerfunktion eine bestimmte Mindestamplitude nicht erreicht wird, in der Berechnung nicht berücksichtigt. Allerdings wird auch für Frequenzen, die in der Erregerfunktion vorhanden sind, aber nicht im Spektrum der angeregten Funktion, der Fourierkoeffizienten Null berücksichtigt.

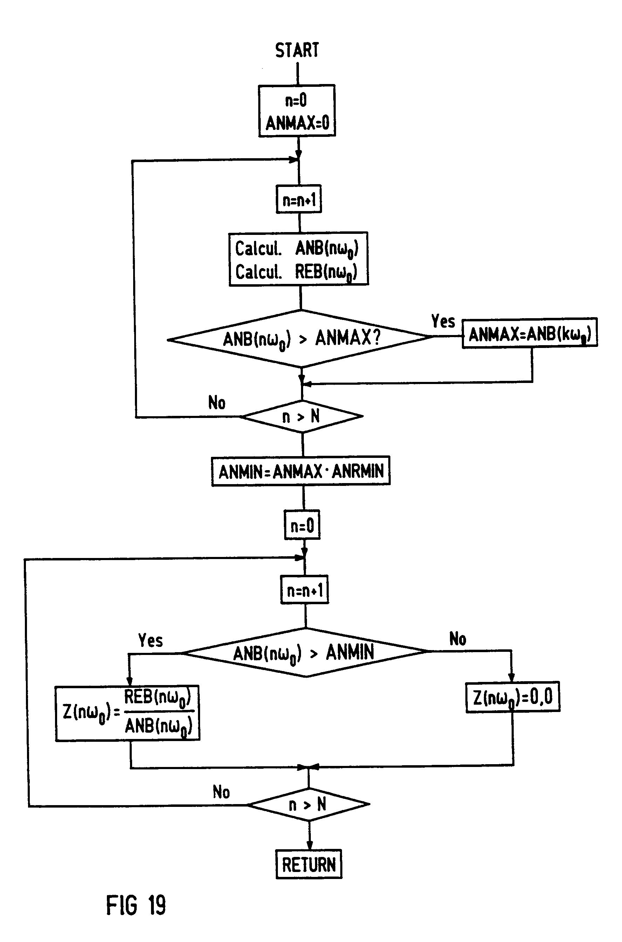

Diese Bereinigung der gemessenen Fourierkoeffizienten wird durch das in Fig. 19 gezeigte Unterprogramm vorgenommen. Im ersten Teil dieses Programms wird zuerst der Maximalwert ANMAX im Spektrum der anregenden Funktion ANB(n.ωO) bestimmt. Sodann wird ein relativer Schwellwert ANRMIN vorgegeben und mit dem Maximalwert ANMAX multipliziert, um einen Schwellwert ANMIN zu erhalten. Anschließend wird für alle Oberfrequenzen n . ωO überprüft, ob der entsprechende Wert $ANB(n.\omega_O)$ der Fouriertransformierten Anregungsfunktion über diesem Schwellwert liegen. Ist dies nicht der Fall, wird die gesuchte Übertragungsfunktion, z.B. die Impedanzfunktion Z(n.ωO) gleich dem Wert Null gesetzt, im anderen Fall wird der Quotient der Fouriertransformierten beider Störfunktionen gebildet.

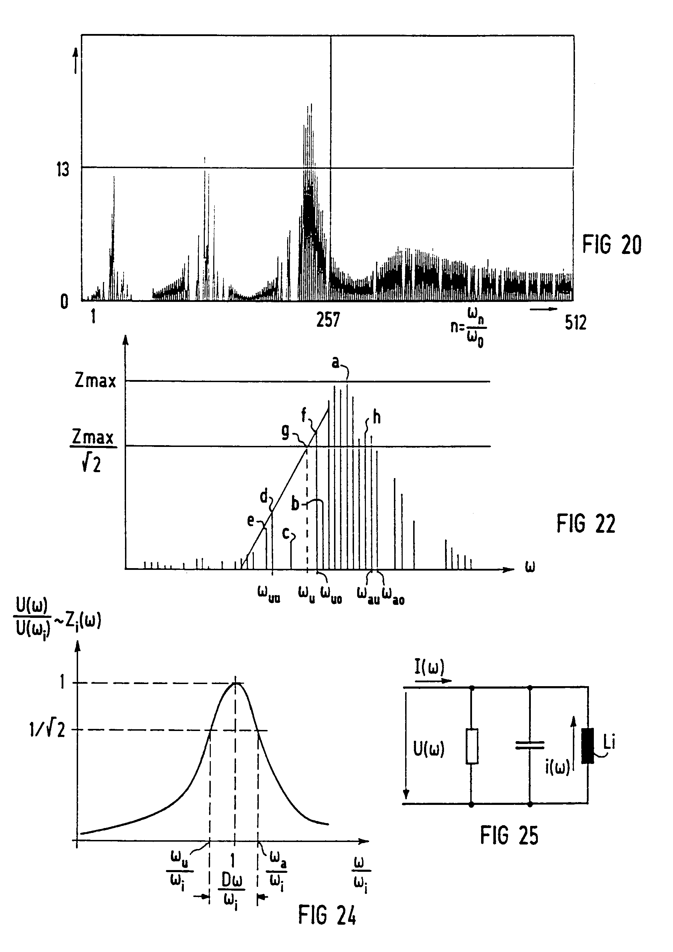

FIG 20 zeigt das zu FIG 18 gehörende, nunmehr bereinigte Spektrum der Übertragungsfunktion.

Sind im gemessenen Impedanzverlauf auch nach der Bereinigung noch starke Abweichungen benachbarter Werte vorhanden, wie dies z.B. in FIG 20 für die niedrigeren Frequenzen deutlich wird, so müssen diese starken Schwankungen vom Identifikationsrechner geglättet werden. FIG 21 zeigt die Struktur des entsprechenden Programmteils MAX, das anhand von FIG 22 näher erläutert wird. Der Programmteil MAX des Identifikationsrechners dient dazu, die Maxima einer geglätteten Impedanzfunktion nach folgenden Kriterien zu finden:

Zunächst wird ein Maximalwert DMAX für die Hälfte der Halbwertsbreite vorgegeben. Diese Maßnahme hat zur Folge, daß enger liegende Maxima zu einem Maximum zusammengefaßt werden. Die maximale Anzahl der Maxima ist auf M/(2.DMAX + 1) begrenzt. Niedrigere Maxima werden also einem engbenachbarten größeren Maximum zugeschlagen.

Oberfrequenzen $\omega_n$, die wegen fehlender Anregung im Programm nach Fig. 19 ausgesondert wurden und deren Impedanzwert $Z(\omega_n) = O$ gesetzt wurde, werden übergangen.

Oberfrequenzen $\omega_n$ werden nur dann als Resonanzfrequenzen $\omega_i$ akzeptiert, wenn für alle Oberfrequenzen $\omega_j$, deren Ordnung j zwischen i + DMAX und i-DMAX liegen, eine Impedanz $Z(\omega_j)$ besitzen, die kleiner ist als $Z(\omega_i)$.

Oberfrequenzen werden außerdem nur dann als Resonanzfrequenzen $\omega_i$ akzeptiert, wenn es (sowohl für kleinere wie für größere Frequenzen) in einem Bereich, in dem alle Amplituden größer sind als $Z(\omega_i)/\sqrt{2}$, es keinen Wert $\omega_j$ gibt, für den $Z(\omega_j)$ größer ist als $Z(\omega_i)$. Die Grenzen dieses Bereiches werden überprüft, indem festgestellt wird, ob für die nächste zugelassene Frequenz außerhalb des Bereiches die Impedanzfunktion kleiner ist als für die Frequenz, die diese Bereichsgrenze markiert.

13

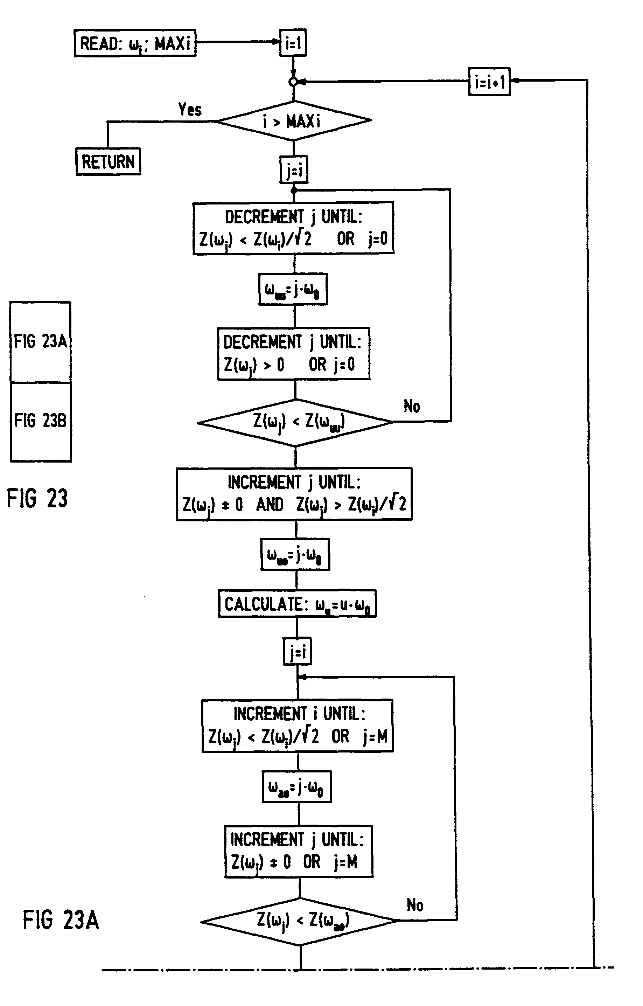

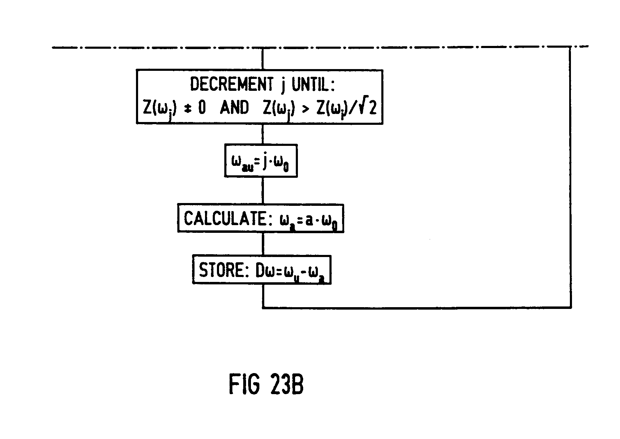

Beim Programm nach FIG 23 wird zunächst mit der Oberfrequenz $\omega_k$ begonnen, für die k = DMAX gilt. Daraufhin wird k inkrementiert, wobei überprüft wird, ob k größer ist als M-DMAX. Diese Bedingung markiert den Ausstieg aus dem Unterprogramm.

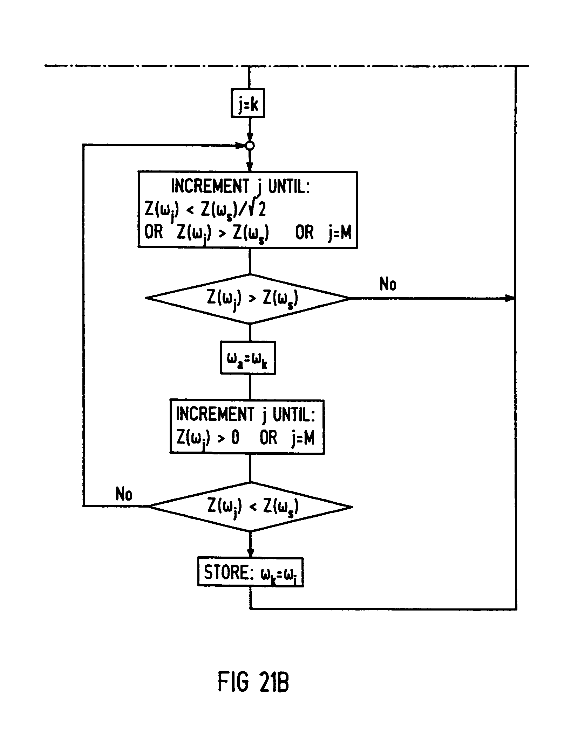

Die Ordnung k wird solange inkrementiert, bis sich innerhalb des durch DMAX bestimmten Bereiches um $\omega_k$ keine Impedanz mehr findet, die größer ist als $Z(\omega_k)$. In dem Ausschnitt eines möglichen Spektrums, das in FIG 22 gezeigt ist, findet man auf diese Weise die mit d bezeichnete Spektrallinie.

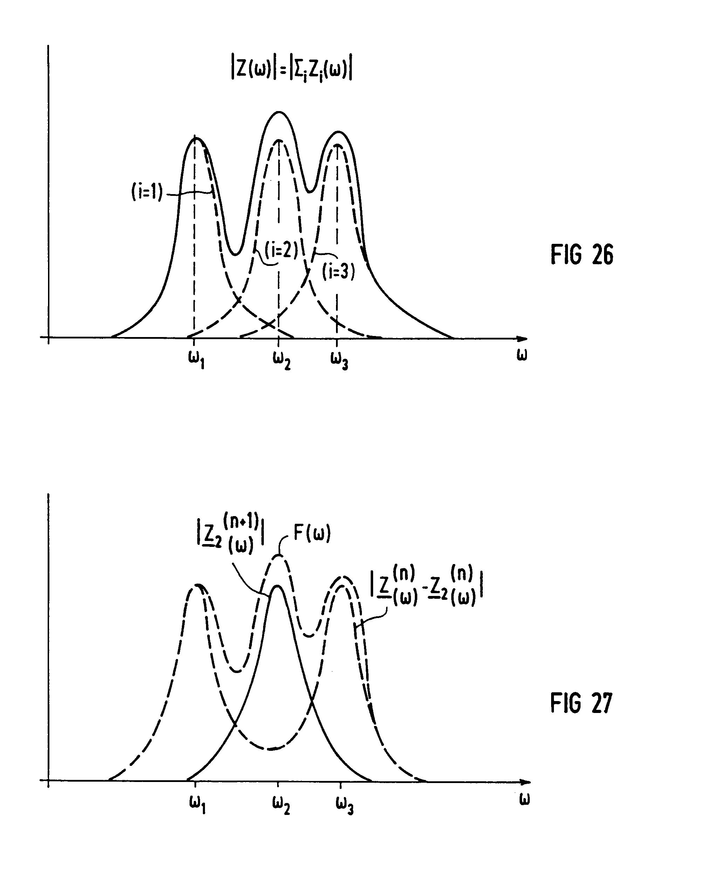

Um festzustellen, ob diese Linie den genannten Kriterien genügt, wird die nächste niedrigere Oberfrequenz $\omega_j$ gesucht, deren Impedanz $Z(\omega_j)$ entweder kleiner ist als $Z(\omega_k)/\sqrt{2}$, also außerhalb der tatsächlichen Bandbreite der als Resonanzfrequenz betrachteten Frequenz $\omega_k$, oder dessen Impedanz größer ist als der Wert $Z(\omega_k)$, der bisher als Maximum akzeptiert ist. Dabei wird die Spektrallinie J = $\ell$ gefunden, die betragsmäßig kleiner ist als die Linie k = d und sogar kleiner ist als $Z(\omega_k)/\sqrt{2}$. Entsprechend wird diese Frequenz $\omega_j$ als untere Grenzfrequenz $\omega_u$ im Sinne der FIG 24 betrachtet.

Ist allerdings die Impedanz für diesen Wert Null, weil diese Frequenz im Programm nach FIG 19 ausgesondert wurde, so wird die Dekrementierung von j weitergeführt, bis entweder die Grundfrequenz (d.h. j = O) erreicht ist, oder ein angeregter Impedanzwert gefunden wird. Sollte dieser nächste, außerhalb der Bandbreite liegende Wert aber größer sein als $Z(\omega_u)$, so wird $\omega_u$ als Grenzfrequenz verworfen und die Dekrementierung von j fortgesetzt.

Anschließend wird, wiederum beginnend von der vorläufig als Resonanzfrequenz akzeptierten Frequenz $\omega_k$, die gleiche Untersuchung für höhere Frequenzen durch Inkrementierung der Ordnung j fortgesetzt. Dabei zeigt sich, daß die Linie c zwar kleiner ist als $Z(\omega_d)/\sqrt{2}$ (Linie d), trotzdem kann aber diese Linie c nicht als obere Grenzfrequenz $\omega_a$ im Sinne der FIG24 akzeptiert werden, da der nächste gültige Wert, nämlich die Linie f, größer ist als die Linie d, die zunächst als Maximum akzeptiert war.

Daher wird die Spektrallinie d als Maximum verworfen und die Inkrementierung der Ordnung k fortgesetzt. Dabei wird zunächst die Linie a als eine Linie identifiziert, die innerhalb der Umgebung DMAX ein Maximum darstellt. Als Frequenz $\omega_j$, deren Impedanz $Z(\omega_j)$ kleiner ist als $Z(\omega_k)/\sqrt{2}$, wird zunächst die Linie b gefunden, aber als Wert für $\omega_u$ verworfen, da die nächstniedrigere Frequenz durch die Spektrallinie f gegeben ist, die größer ist als die Spektrallinie b.

Die Suche nach $\omega_u$ führt dann zur Spektrallinie c, die aber ebenfalls verworfen wird, da die Spektrallinie d wieder größer ist. Jedoch gilt für diese Spektrallinie d nunmehr $Z(\omega_j)<Z(\omega_k)/\sqrt{2}$ und stellt somit einen akzeptierten Wert für die untere Grenzfrequenz dar.

Die entsprechende Suche nach einer oberen Grenzfrequenz führt ebenfalls zum Erfolg, so daß die Linie a als Maximum erkannt und ihre Frequenz als Resonanzfrequenz $\omega_i$ und ihre Amplitude als Maximum $Z(\omega_i)$ in einen Speicher eingegeben werden kann und für die weitere Berechnung zur Verfügung steht.

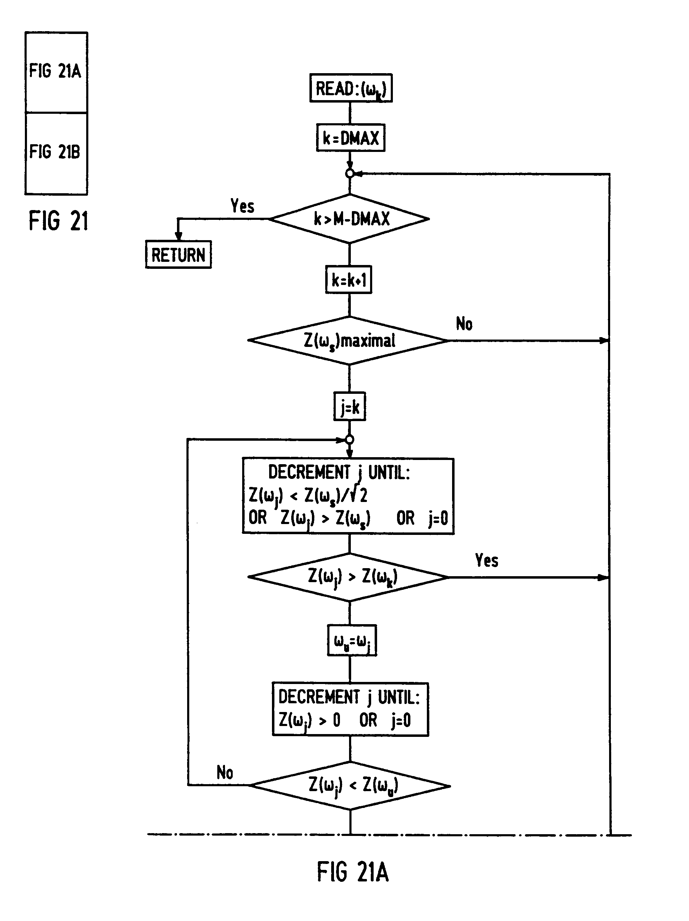

Im Programmteil HW wird nun die Halbwertsbreite für jedes Maximum ermittelt. Dazu wird zunächst bei kleineren Frequenzen der Wert $\omega_{uO}$ und $\omega_{uu}$ gesucht, dessen Impedanzen größer und kleiner sind als $Z(\omega_i) \cdot /\sqrt{2}$. Dies sind für die Maximallinie a zunächst die Linien f und b. Da jedoch die Linie b (und auch die Linie c) jeweils kleiner sind als die Linie der nächstniedrigeren Oberfrequenz f (bzw. d), werden auf die bereits im Programm der FIG 21 gezeigte Weise die Linien b und c verworfen und erst die Linie d gibt einen gültigen Wert von $\omega_{uu}$ an. Dieses Verfahren wird auch für höhere Frequenzen durchgeführt, um die Werte $\omega_{au}$ und $\omega_{aO}$ zu finden.

Durch diese Punkte kann nun eine Gerade gelegt werden, wie in FIG 22 gezeigt ist, um den zu $Z(\omega_i)/\sqrt{2}$ gehörenden Frequenzwert $\omega_u$ bzw. $\omega_a$ zu finden. Dies geschieht rechnerisch nach den Gleichungen

$$\omega_u = \frac{(\omega_{uo} - \omega_{uu}) \cdot Z(\omega_i)/\sqrt{2} + Z(\omega_{uo}) \cdot \omega_{uu} - Z(\omega_{uu}) \cdot \omega_{uo}}{Z(\omega_{uo}) - Z(\omega_{uu})}$$

$$\omega_a = \frac{(\omega_{ao} - \omega_{au}) \cdot Z(\omega_i)/\sqrt{2} + Z(\omega_{ao}) \cdot \omega_{au} - Z(\omega_{au}) \cdot \omega_{ao}}{Z(\omega_{ao}) - Z(\omega_{au})}$$

aus denen sich die Bandbreite ergibt:

$$\Delta\omega = \omega_a - \omega_u$$

Das hierzu gehörende Programm ist in FIG 23 angegeben.

Im Programmteil PAR werden die Resonanzfrequenzen $\omega_i$, ihre Amplituden $Z(\omega_i)$ sowie Halbwertsbreiten gespeichert und gegebenenfalls in $L_i$, $C_i$ und $R_i$ umgerechnet.

Um nun aus diesem gemessenen Frequenzverlauf der Impedanzfunktion einen angenäherten Verlauf der Impedanzfunktion des Netzmodelles zu bestimmen, ist in FIG 25 zunächst ein mit dem Index i bezeichneter Parallelschwingkreis dargestellt, wie er beim Netzmodell nach FIG 13 vorgesehen ist. FIG 24 zeigt die spektrale Verteilung der Impedanz im Fall, daß dem Schwingkreis der FIG 24 ein konstanter Strom $I(\omega)$ von außen zugeführt wird. Entsprechend ergibt sich die dabei auftretende Spannung $U(\omega)$, die für die Resonanzfrequenz $\omega = \omega_i$ den Maximalwert $U(\omega_i)$ aufweist. Der durch die Impedanz Li fließende Strom $i(\omega)$ nimmt für diesen Resonanzfall ($\omega = \omega_i$) hohe Werte an und lädt den Kondensator CI auf die Spannung $U(\omega)$ auf, wobei der Spannungsabfall am Widerstand $R_i$ von dem von außen eingespeisten Strom $I(\omega)$ kompensiert wird. Der Strom $i(\omega)$ kann also für $\omega = \omega_i$ Werte annehmen, die weit höher liegen als $I(\omega)$ und Ursache der anfangs erwähnten Störungen im Netz sind.

Für die Resonanzfrequenz $\omega_i = 1/\sqrt{L_i.C_i}$ ist der Impedanzwert $Z(\omega_i) = U(\omega_i)/I(\omega_i)$ durch den Widerstand $R_i$ gegeben, während die Dämpfung D durch $\omega_i.L_i/R_i = 1/(\omega_i.C_i.R_i) = \sqrt{L_i/C_i}/R_i$ gegeben ist. Definiert man eine obere Grenzfrequenz $\omega_a$ und eine untere Grenzfrequenz $\omega_u$ als diejenigen Werte, für die $Z(\omega_u) = Z(\omega_a) = Z(\omega_i)/\sqrt{2}$ gilt, so gilt für die Bandbreite $B = (\omega_a - \omega_u)/2 = D.\omega_i = R_i/L_i = C_i.R_i$. Resonanzfrequenz und Dämpfung bzw. $R_i$, $C_i$ und $L_i$ können also aus der Impedanzkurve abgelesen werden.

Besitzt der gemessene Impedanzverlauf $F(\omega_i)$ also nur ein Maximum, so wird man das Netzmodell zweckmäßig mit einem einzigen Schwingkreis konzipieren, der den in FIG 24 gezeigten Verlauf $Z_i(\omega)$ der Impedanz aufweist. Dieser ist innerhalb seiner Bandbreite um die Resonanzfrequenz $\omega_i$ herum näherungsweise mit $F(\omega_n)$ identisch, d.h. es gilt

$$|\underline{F}(\omega)| \approx |\underline{Z}_i(\omega)| \qquad \text{für } \omega \approx \omega_i$$

Für einen Impedanzverlauf mit N Maxima werden auch N Schwingkreise mit den Resonanzfrequenzen $\omega_i$ benötigt. In der Nähe jedes Maximus gilt

$$|\underline{F}(\omega)| \approx |\underline{Z}_1(\omega) + \underline{Z}_2(\omega) + ... \underline{Z}_N(\omega)| \qquad \text{für } \omega \approx \omega_1, ..\omega_N.$$

Liegen die Resonanzfrequenzen weit auseinander und sind ihre Bandbreiten gering, so wird der i-te Schwingkreis von der Gesamtheit der anderen Schwingkreise praktisch nicht beeinflußt.

Es gilt also

$$\left| \underline{Z}_i(\omega) \right| \gg \left| \sum_{j=1,...,N; \, j \neq i} \underline{Z}_j(\omega) \right| \qquad \text{für } \omega \approx \omega_i$$

und man kann näherungsweise auch für die diskreten Frequenzen $\omega_n$ im Frequenzspektrum der FIG 20 setzen

$$F(\omega_n) = |Z_i(\omega_n)|$$

Man erhält also dadurch, daß aus dem gemessenen Impedanzverlauf in der Nähe jedes Maximums die Parameter eines Ersatzschwingkreises berechnet werden, eine erste Annäherung der Impedanzfunktion des Netzmodelles an die gemessene Übertragungsfunktion.

In FIG 26 ist für ein System aus N = 3 Schwingkreisen mit den gestrichelten Linien (i = 1), (i = 2) und (i = 3) jeweils die Resonanzkurve für den Betrag der Impedanz eines einzelnen Schwingkreises angegeben. Die vollständige Wechselstromimpedanz, wie sie sich durch die Fourieranalyse ergibt, enthält aber noch einen frequenzabhängigen Phasenwinkel, der zwischen $+ \pi/2$ und $- \pi/2$ liegt und in der Nähe der Resonanzfrequenz einen Nulldurchgang aufweist. Sind die Schwingkreise, wie dies im Netzmodell angenommen wird, direkt aneinander gekoppelt, so wird die Resonanzschwingung eines benachbarten Schwingkreises sowohl von der Phasenlage wie von der Amplitude der im benachbarten Schwingkreis angeregten Schwingung beeinflußt. Die Gesamtimpedanz $\underline{Z}(\omega)$ ergibt sich zwar als Summe der Einzelimpedanzen $\underline{Z}_i(\omega)$, wobei mit i = 1,...N die einzelnen Resonanzkreise gezählt werden.

Für den Betrag der Impedanzfunktion kann aber die Betragsbildung nur für die gesamte Summe, nicht für die einzelnen Summanden vorgenommen werden. Da die bisher betrachtete, erste Näherung zur Bestimmung der Parameter des Ersatzschwingkreises nur von einer isolierten Betrachtung eines einzelnen Impedanzmaximums ausgeht, wird also ein Fehler begangen, der im Programmschritt KOR korrigiert werden soll.

Da die Programmteile MAX, HW, PAR und KOR in einer Iterationsschleife angeordnet sind, wird das hierzu vorgeschlagene Verfahren gleich für den Fall erläutert, daß die Schleife (n)-mal durchlaufen ist und somit für jeden mit i gekennzeichneten Schwingkreis bereits ein (n)-mal korrigierter Parameterwert

$$R_i^{(n)}, \quad C_i^{(n)} \quad \text{und} \quad L_i^{(n)}$$

zur Verfügung steht, der die entsprechende isolierte Impedanz aufweist:

$$\underline{Z}_i^{(n)}(\omega) = \frac{1}{1/R_i^{(n)} + j(\omega \cdot C_i^{(n)} - 1/\omega \cdot L_i^{(n)})}$$

Das Netzmodell besitzt in dieser Näherung dann als Übertragungsfunktion die Summe aller isolierten Impedanzen:

$$\underline{Z}^{(n)}(\omega) = \sum_i Z_i^{(n)}(\omega)$$

Für den Schwingkreis i = j soll dessen isolierte Impedanz

$$\underline{Z}_j^{(n)}(\omega)$$

ersetzt werden durch

$$\underline{Z}_j^{(n+1)}(\omega) = \underline{Z}_j^{(n)}(\omega) + \Delta \underline{Z}_j(\omega)$$

wobei wenigstens das j-te Maximum des Netzmodells durch die Korrekturfunktion

$$\Delta \underline{Z}_j(\omega) = \underline{F}(\omega) - \underline{Z}^{(n)}(\omega)$$

an die gemessene Impedanz $\underline{F}(\omega)$ des Netzes angenähert wird. Es gilt also:

$$\underline{Z}_j^{(n+1)}(\omega) = \underline{F}(\omega) - \underline{Z}^{(n)}(\omega) + \underline{Z}_j^{(n)}(\omega)$$

Der Betrag $|\underline{F}(\omega)|$ der komplexen Netzimpedanz ist durch die Fouriertransformation gemessen, während die Phasenlage durch die Modellimpedanz näherungsweise bestimmt ist. Daher kann gesetzt werden:

$$\underline{F}(\omega) = |\underline{F}(\omega)| \cdot \frac{\overset{(n)}{\underline{Z}}(\omega)}{|\overset{(n)}{\underline{Z}}(\omega)|}$$

Für die verbesserte isolierte Impedanzfunktion ergibt sich also

$$\underline{Z}_j^{(n+1)}(\omega) = |\underline{F}(\omega)| \cdot \frac{\overset{(n)}{\underline{Z}}(\omega)}{|\overset{(n)}{\underline{Z}}(\omega)|} - \overset{(n)}{\underline{Z}}(\omega) + \overset{(n)}{\underline{Z}}_j(\omega)$$

und aus dem Betrag dieser Funktion

$$|\underline{Z}_j^{(n+1)}(\omega)| = |\underline{Z}_j^{(n)}(\omega) + |\underline{F}(\omega)| \cdot \frac{\overset{(n)}{\underline{Z}}(\omega)}{|\overset{(n)}{\underline{Z}}(\omega)|} - \overset{(n)}{Z}(\omega)|$$

ergeben sich Resonanzfrequenz, Amplitude und Halbwertsbreite, die eine verbesserte Bestimmung der konzentrierten Schwingkreisparameter darstellen.

FIG 27 veranschaulicht, wie aus dem gemessenen Betrag der komplexen Übertragungsfunktion und den Übertragungsfunktionen der Schwingkreise (i = 1) und (i = 3) der FIG 26 die isolierte mit durchgezogener Linie gezeichnete Impedanzfunktion

$$|Z_2^{(n+1)}(\omega)|$$

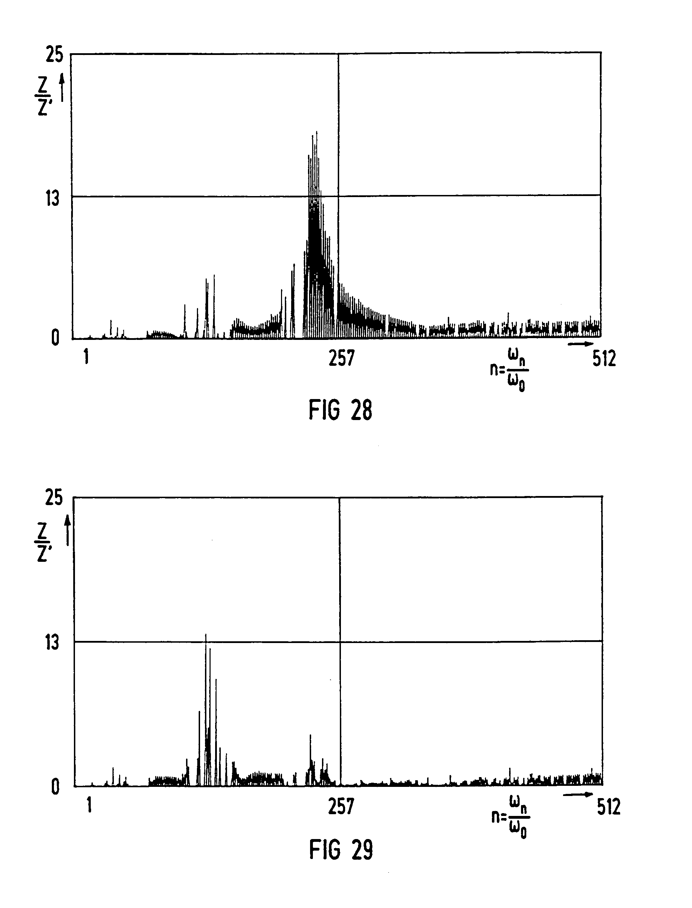

des isolierten Schwingkreises (i = 2) bebildet wird. Auf diese Weise kann in vier Iterationen aus dem Spektrum der Fig. 20 das Spektrum einer isolierten Resonanz bei der Frequenz $\omega_i = n_i . \omega_0$ ermittelt werden, das in FIG 28 für $n_i \approx 250$ und in FIG 29 für $n_i \approx 120$ gezeigt ist. Gegenüber der ersten Näherung haben sich die Parameter der einzelnen Ersatzschwingkreise um etwa 30 % verbessert.

Außerdem kann es vorkommen, daß im gemessenen Impedanzspektrum zunächst mehrere einzelne Maxima identifiziert werden, die aber im Laufe der Iterationen als Artefakte erkannt werden und sich als rechenbedingte oder meßfehlerbedingte Schwankungen innerhalb des Bereiches einer einzigen Resonanz herausstellen. Dies tritt besonders auf, wenn als Kriterium für ein Maximum im Programm MAX nur gefordert wird, daß in der durch die maximale Halbwertsbreite vorgegebenen Umgebung einer Resonanzfrequenz keine andere Impedanz größer sein soll als die Resonanzimpedanz. Werden jedoch die im Programm nach FIG 22 aufgestellten, schärferen Kriterien angewendet, so werden Scheinmaxima, die lediglich durch Systemfehler entstehen, bereits weitgehend unterdrückt. Die Ermittlung der Parameter braucht daher häufig nur alternativ nach FIG 22 oder dem Programmteil KOR vorgenommen zu werden.

Die beschriebene Korrektur ist vor allem für Maxima, die große Werte annehmen und/oder nahe beieinanderliegen, vorteilhaft. Kleine Maxima dagegen können unterdrückt oder ohne Iteration weiterbehandelt werden, ohne daß dadurch ein wesentlicher Fehler begangen wird. Dies kann besonders dann vorteilhaft sein, wenn bei der erwähnten Subtraktion

$$Z_j^{(n)}(\omega) - Z*^{(n)}(\omega)$$

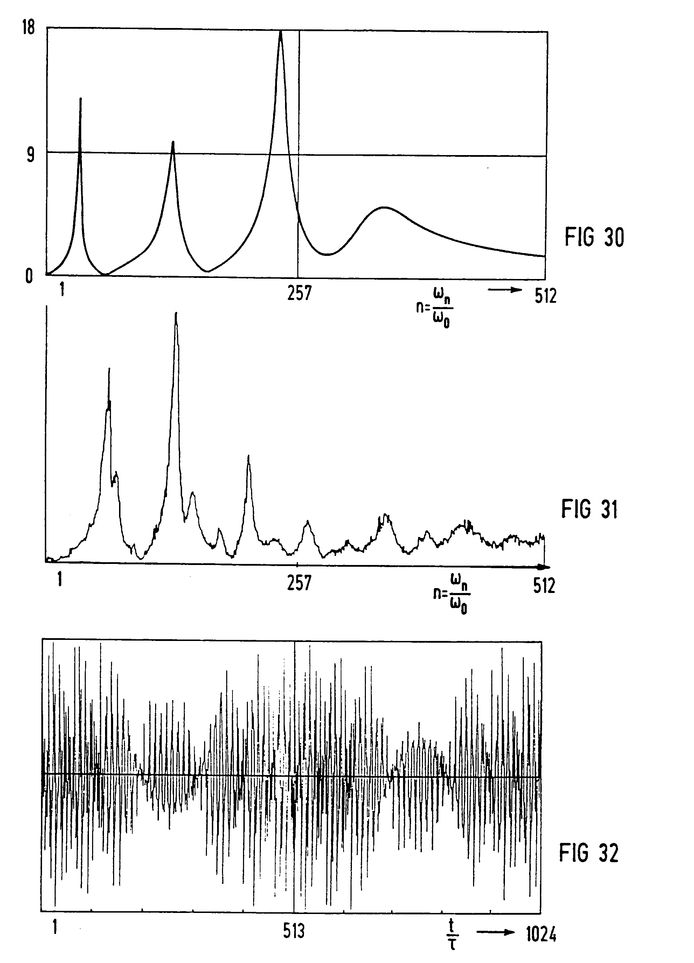

der Subtrahend größer als der Minuend wird, so daß im Laufe der Iteration der zu einem derartigen "kleinen Maximum" gehörende Impedanzwert an wächst, was zu einer Divergenz des Algorithmus führen kann. FIG 30 zeigt nunmehr für die bereits in FIG 20 dargestellte Übertragungsfunktion die angenäherte Übertragungsfunktion, die aus dem derart berechneten Netzmodell als kontinuierliche Kurve errechnet ist.

Wird als Identifikationsrechner ein Signalprozessor TMS 320 C25 der Firma Texas Instrument eingesetzt, so zeigt sich, daß für die Fourier-Transformation der eingetasteten Meßwerte von Strom und Spannung etwa 35 ms benötigt werden. Bei der daraus folgenden Berechnung des Impedanzwertes ist vor allem das Bilden der Quadratwurzel und die Division zeitraubend, so daß für die Berechnung der Impedanz einer angeregten Oberwelle etwa 0,11 ms benötigt werden. Die Berechnung des gesamten Impedanzverlaufes hängt stark von der Anzahl der angeregten Oberwellen ab und beträgt im ungünstigsten Fall, bei dem alle 512 Oberwellen angeregt sind, 60 ms. Die Suche nach den Maxima und Bandbreiten erfordert weitere 20 ms. Außerdem muß das Programm bei jedem Durchlauf für das Einlesen der M = 1024 Abtastwerte unterbrochen werden, so daß weitere 10 ms zu addieren sind. Daraus ergibt sich eine Gesamtrechenzeit des Identifikationsrechners, die je nach Anregung der Oberwellen zwischen 70 ms und 125 ms liegt.

Dies ist etwas mehr als die Periodendauer der Spannungen und Ströme, die im deutschen Bahnnetz 60 ms beträgt. Es genügt aber, auf der Lokomotive zwischen dem Stromabnehmer und dem Wechselrichter nur in jeder dritten Periode die elektrischen Größen abzutasten, um aus den dabei gebildeten Meßgrößen sofort ("on-line") ein optimiertes Pulsmuster für den Stromrichterbetrieb zu errechnen.

Soll das vollständige Impedanzspektrum des Netzes aufgenommen werden, so kann der Stromrichter mit einem stochastisch veränderlichen Pulsmuster betrieben werden, dessen Ausgangsgrößen daher alle Oberfrequenzen anregen. FIG 31 zeigt die entsprechende Übertragungsfunktion des Netzes.

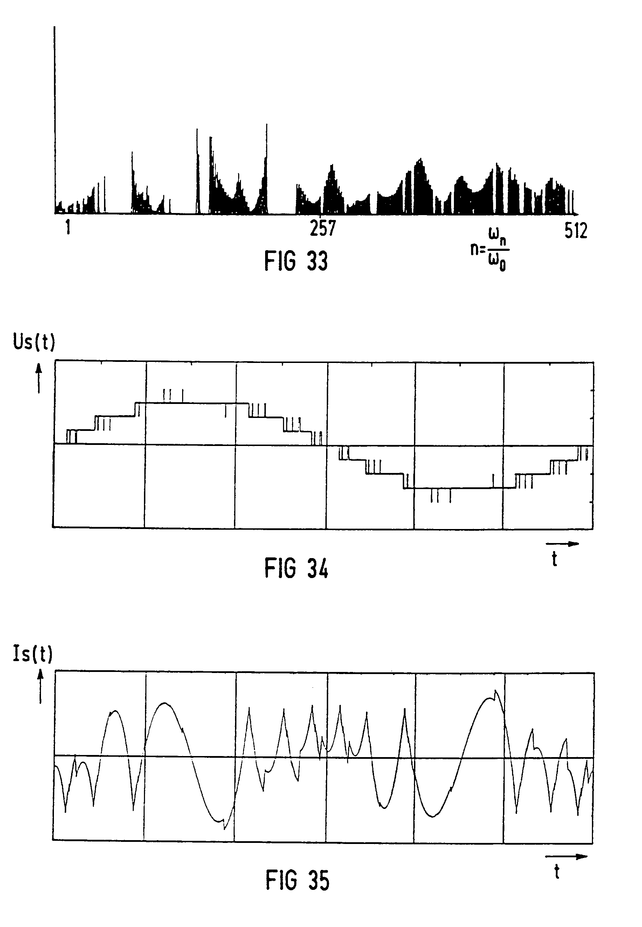

Im gleichen Zustand des Netzes enthält aber die Ausgangsspannung eines Stromrichters, der die Motoren einer Lokomotive nach FIG 3 speist, nur die in FIG 32 gezeigte Störspannung, in der manche Frequenzbereiche nicht angeregt sind. FIG 33 zeigt das dabei meßbare Frequenzspektrum der Netzimpedanz.

In den Figuren 5 bis 12 sind die vom Pulsmuster vorgegebene Anschlußspannung $U_s(t)$ des Stromrichters, sein Störstrom, die Frequenzspektren der Störspannung am Stromrichter und am Fahrdreht und die räumliche Verteilung der Amplituden von Störspannung und Störstrom längs des Fahrdrahtes bereits dargestellt. Diese Größen ändern sich ständig während der Fahrt.

Die erfindungsgemäß gebildeten Resonanzmeßgrößen führen nach Optimierung einer daraus abgeleiteten Zielfunktion (z.B. der in den Schwingkreisen des Netzmodelles virtuell gespeicherten Energie) zu einem Pulsmuster und einer Spannung Us(t), die in in FIG 34 gezeigt ist.

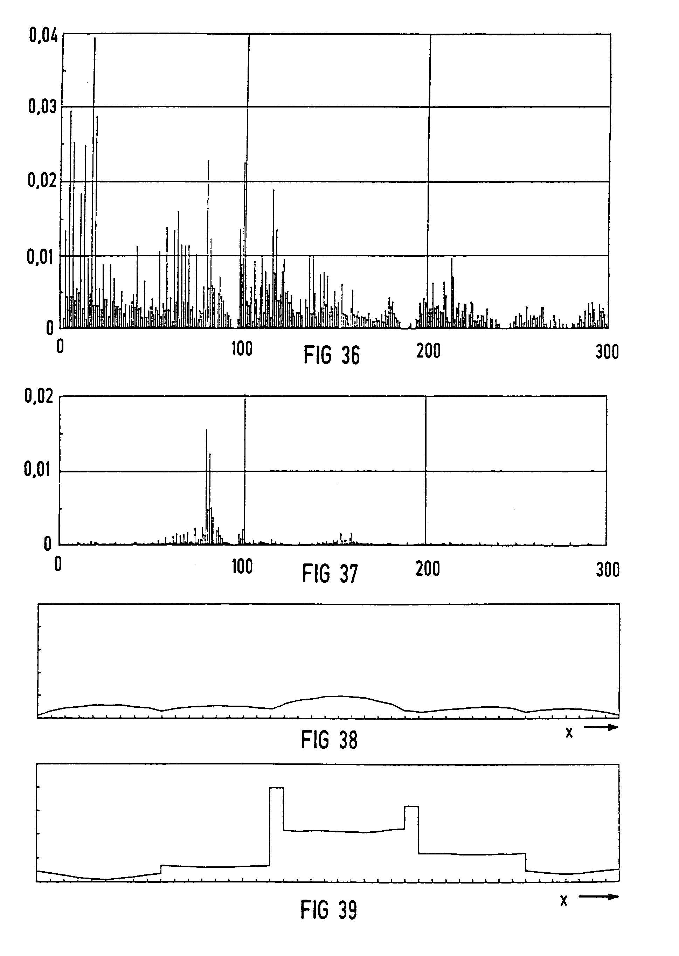

FIG 35 zeigt den dabei auftretenden Störstrom. Die dabei auftretenden, den Figuren 8 und 9 entsprechenden Frequenzspektren der Störspannung sind in FIG 36 und 37 wiedergegeben und zeigen am Stromrichter eine wesentliche Verschiebung der Maxima in einem wesentlich gleichmäßiger angeregten Spektrum, während am Stromabnehmer nur noch schwache Maxima der Netzspannung auftreten.

Die Amplitude und räumliche Verteilung der Störspannung ist jetzt wesentlich weniger ausgeprägt (FIG 38) und der ins Netz eingespeiste, unvermeidliche Störstrom, der in FIG 39 in gegenüber FIG 12 vergrößertem Maßstab dargestellt ist, fließt weitgehend über die benachbarten Unterwerke ab. Es kommt somit im Netz nicht zu Parallelresonanzen und stehenden Wellen von Strom und Spannung.

Um die Übertragungsfunktion aus den elektrischen Größen zu bestimmen, ohne die in den FIG 16 bis 23 erläuterten, zeitraubenden Berechnungen durchzuführen, können die Koeffizienten $\underline{Z}(\omega_u)$ dieser Übertragungsfunktion auch aus Fourierkoeffizienten der elektrischen Größen bestimmt werden, die jeweils in mehreren Perioden gemessen und anschließend gemittelt werden.

Dadurch werden stochastische Schwankungen in der gemessenen Übertragungsfunktion ausgemittelt. Außerdem können die Fourierkoeffizienten nicht nur betragsmäßig, sondern auch vollständig als komplexe Zahlen erfaßt werden.

Soll z.B. die Übertragungsfunktion

$$\underline{G}(\omega_n) = \underline{U}n(\omega n)/\underline{U}s(\omega_n)$$

bestimmt werden, so liefert die bereits beschriebene Fast-Fourier-Transformation zunächst für jede Frequenz $\omega_n$ und jede Periode m die komplexen Koeffizienten $\underline{U}n(\omega_n)^{(m)}$, $\underline{U}s(\omega_n)^{(m)}$ und damit auch die dazu konjugiert komplexen Werten $\underline{U}n^*(\omega_n)^{(m)}$ und $\underline{U}s^*(\omega_n)^{(m)}$. Daraus werden die beiden reellen Werte

$$Gnn = \underline{U}n(\omega_n)^{(m)} \cdot \underline{U}n^*(\omega_n)^{(m)}$$
$$Gss = \underline{U}s(\omega_n)^{(m)} \cdot \underline{U}s^*(\omega_n)^{(m)}$$

und der komplexe Korrelationskoeffizient

$$\underline{G}ns = \underline{U}n(\omega_n)^{(m)} \cdot \underline{U}s^*(\omega_n)^{(m)}$$

gebildet, wobei jeweils nur eine komplexe Multiplikation auszuführen ist.

In jeder Periode m kann für die Frequenz $\omega_n$ der Koeffizient der Übertragungsfunktion $\underline{G}(\omega_n)$ bestimmt werden als

$$\underline{G}ns(\omega_n)^{(m)}/Gss(\omega_n)^{(m)}$$

was lediglich die Division durch eine reelle Zahl erfordert.

Vorteilhaft werden jedoch die in jeder Periode berechneten Produkte gemittelt. Dies kann rekursiv in der Periode m unter Verwendung des in der Periode (m-l) gebildeten Mittelwertes

$$\overline{\underline{Gns}}(\omega_n)^{(m-1)}$$

geschehen:

$$\overline{\underline{Gns}}(\omega_n)^{(m)} = \beta \cdot \overline{\underline{Gns}}(\omega_n)^{(m-1)} + (1-\beta) \cdot \underline{Gns}(\omega_n)^{(m)}$$

$\beta$ entspricht dabei der Zeitkonstante eines Glättungsgliedes für einen Meßwert. Entsprechend dem dadurch gebildeten Mittelwert

$$\overline{\underline{Gns}}(\omega_n)$$

können auch die gemittelten ("geglätteten") Produkte $\overline{Gnn}(\omega_n)$ und $\overline{Gss}(\omega_n)$ berechnet werden.

Für zeitlich konstante Meßwerte ergibt sich in jeder Periode dann die Übertragungsfunktion

$$\underline{G}(\omega_n) = \underline{U}n(\omega_n)/\underline{U}s(\omega_n) = \overline{\underline{Gns}}(\omega_n)/\overline{Gss}(\omega_n)$$

Meßwert-Streuungen werden dabei weitgehend unterdrückt.

An dem mittleren komplexen Korrelationskoeffizient

$$\overline{\underline{Gns}}(\omega_n)$$

läßt sich durch Normierung ein Plausibilitätsfaktor bilden:

$$P(\omega_n) = \overline{\underline{Gns}}(\omega_n)^2/(\overline{Gnn}(\omega_n) \cdot \overline{Gss}(\omega_n))$$

wobei

$$\overline{\underline{Gns}}(\omega_n)^2$$

das Quadrat des Mittelwertes oder - bevorzugt - der Mittelwert des Quadrates von $\underline{G}ns(\omega_n)$ ist. $P(\omega_n)$ ist eine reelle Zahl, die für zeitlich konstante Meßwerte den Wert l annimmt, während sich bei stochastischen Beziehungen zwischen Betrag und Phase der beiden elektrischen Größen der Wert Null ergibt.

Um also bei der Annäherung der Modell-Übertragungsfunktion an die gemessene Übertragungsfunktion $\underline{G}(\omega_n)$ oder $\underline{Z}(\omega_n)$ nur plausible Meßwerte zu berücksichtigen, kann eine aus $P(\omega_n)$ gebildete Gewichtsfunktion eingeführt werden. Dabei werden Frequenzen mit hohem $P(\omega_n)$ stark berücksichtigt, bei kleinem $P(\omega_n)$ aber

praktisch unterdrückt (z.B. Gewicht "I" für $P(\omega_n) \geq 0{,}8$ und Gewicht "O" für $P(\omega_n) < 0{,}8$).

Die komplexe Übertragungsfunktion erfaßt (z.B. über die Terme $\underline{G}ns(\omega_n)$ und $Gss(\omega_n)$)) auch die erwähnten Lauf- und Totzeiteffekte, die durch die räumliche Ausdehnung des Netzes hervorgerufen werden. Diese beeinflussen Betrag und Argument der Übertragungsfunktion, können und sollen aber im virtuellen Modell nur soweit berücksichtigt werden, als sie bei einer Resonanz des Netzes die Energieaufnahme und Dämpfung bestimmen.

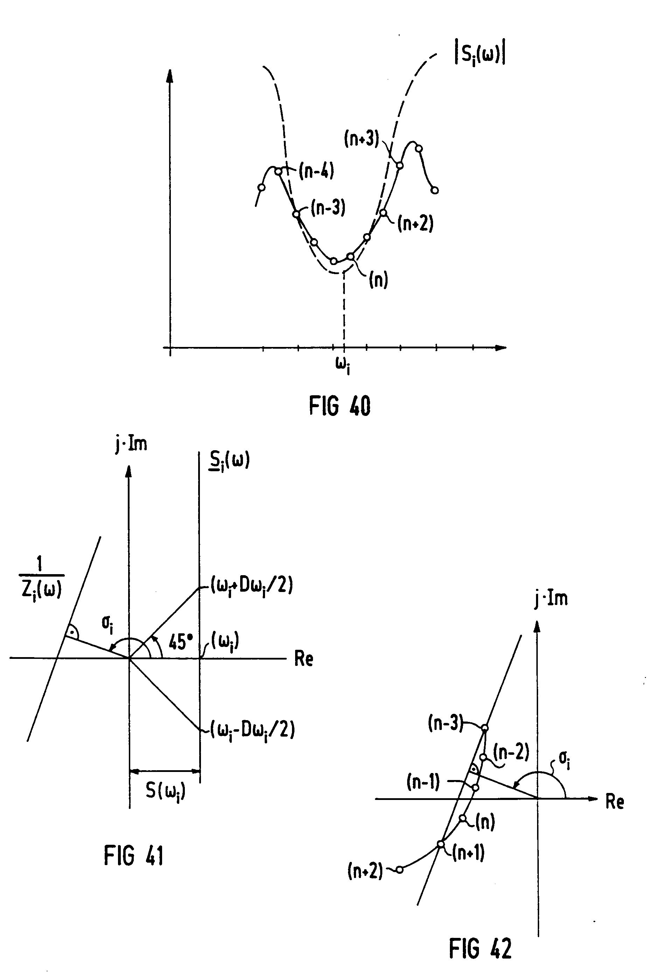

Um die Annäherung der Modell-Übertragungsfunktion $\underline{Z}(\omega)$ an die gemessene Übertragungsfunktion $\underline{G}(\omega)$ mit wenig Aufwand durchführen zu können, wird bei dieser Variante vom Kehrwert $1/\underline{G}(\omega)$ bzw. $1/\underline{Z}(\omega)$ ausgegangen. In FIG 40 ist schematisch der Kehrwert des in FIG 26 gezeigten Betrages der Übertragungsfunktion in der Nähe der Resonanzfrequenz $\omega_i$ des Schwingkreises mit dem Index i = 2 dargestellt. Mit (n-3),...(n)...(n+3) sind die Meßpunkte für die Ordnungen $\omega_n/\omega_o$ der auf die Netz-Grundfrequenz $\omega_o$ bezogenen Oberschwingungen bezeichnet. In der Nähe der Resonanzfrequenz $\omega_i$ soll diese Kurve durch das Modell, am einfachsten durch die Übertragungsfunktion $|\underline{S}_i(\omega)| = 1/|\underline{Z}_i(\omega)|$ eines einzigen Schwingkreises, angenähert werden. Die in FIG 26 und 27 behandelte gegenseitige Beeinflussung der Schwingkreise des Modells wird bei dieser Näherung also zunächst innerhalb des Annäherungsbereiches, der die Meßpunkte (n-3)...(n+2) umfaßt, vernachlässigt. Die entsprechende, einer besten Annäherung entsprechende Übertragungsfunktion $|\underline{S}_i(\omega)|$ ist eben falls in FIG 40 dargestellt.

Die vollständige komplexe Funktion $\underline{S}_i(\omega)$ des Schwingkreises i ist als komplexe Funktion in der komplexen Zahlenebene der FIG 41 dargestellt. Sie hat die Gestalt einer Geraden, deren Werte für die Resonanzfrequenz $\omega = \omega_i$ auf der reellen Zahlengeraden liegt, da der Schwingkreis bei dieser Frequenz nur durch seinen ohmschen Widerstand gedämpft ist. Die Halbwertsbreite der Resonanzkurve ist mit $D\omega_i$ bezeichnet.

Wegen der räumlichen Verteilung des tatsächlichen Netzes weist jedoch die gemessene Funktion $1/\underline{G}(\omega_n)$ auch für die Frequenz $\omega_i$ einen Phasenwinkel auf, der mit $\sigma_i$ bezeichnet ist und um den daher die anzunähernde Funktion $\underline{S}_i(\omega)$ in der komplexen Zahlenebene gedreht werden muß. Dies führt zur Funktion

$$\frac{1}{\underline{Z}_i(\omega)} = \left\{ |S_i(\omega_i)| \exp j\sigma_i \right\} \cdot \left( 1 + j \frac{2(\omega - \omega_i)}{D\omega_i} \right)$$

FIG 42 zeigt die Meßpunkte der tatsächlich gemessenen Funktion $1/\underline{G}(\omega_n)$, soweit diese Meßpunkte in dem zur Auswertung herangezogenen Frequenzbereich (n-3),...(n+2) liegen.

An diese Meßpunkte kann die Funktion $1/\underline{Z}_i(\omega)$ auf mathematischem Wege angepaßt werden, z.B. durch Minimierung der Differenzen $(1/\underline{G}(\omega_n) - 1/\underline{Z}_i(\omega))$, oder durch iterative oder rekursive Methoden. Vorzugsweise werden diese Differenzen dabei mit der Funktikon $|G(\omega_n)|$ gewichtet. Aus der angenäherten Funktion $1/\underline{Z}_i(\omega)$ werden dann die Resonanz-Parameter $\omega_i$, $S_i(\omega_i)$ bzw. $1/S_i(\omega_i)$ und $D\omega_i$ bestimmt.

Diese Rechnung ist bereits mit der heute zur Verfügung stehenden Rechengeschwindigkeit handelsüblicher Signalprozessoren so schnell durchführbar, daß jeweils nach einer Periode der Netzspannung aus den dabei abgelesenen Meßwerten der elektrischen Größen innerhalb von weniger als 60 Millisekunden sowohl deren Fourierspektrum berechnet, wie dessen Auswertung abgeschlossen ist. Es steht also nach jeder Periode ein neuer Satz von Meßgrößen zur Verfügung, die den aktuellen Zustand des Netzes in Form eines geeigneten virtuellen Modells beschreiben und die Resonanzeigenschaften zum Zeitpunkt der Messung vollständig erfaßen.

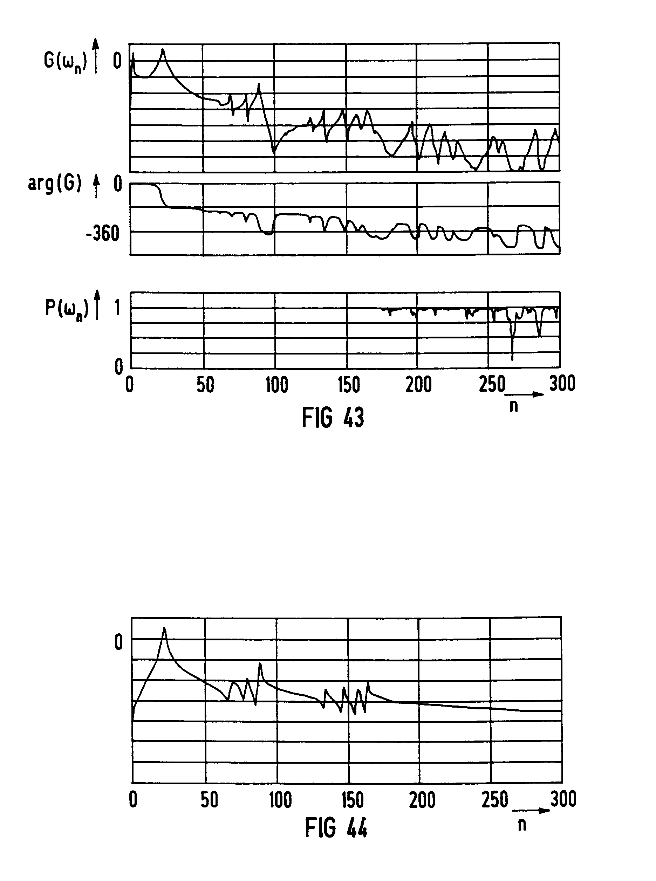

FIG 43 zeigt den Betrag $G(\omega_n)$ und das Argument arg $(\underline{G})$ der komplexen, gemessenen Übertragungsfunktion $\underline{G}(\omega_n)$ sowie den Plausibilitätsfaktor $P(\omega_n)$, die an einer Stelle eines Bahnnetzes von 320 km Länge mit 8 Unterwerken und 2 Lokomotiven aufgenommen wurde. Die weitere Auswertung verwendet folgende Plausibilitätskriterien: Frequenzen $\omega_n$ mit einem Plausibilitätsfaktor $P(\omega_n) \leq 0{,}8$ werden nicht weiter ausgewertet. In der Umgebung eines Maximums $\omega_i$ werden nur Meßpunkte ausgewertet, für die $|\underline{G}(\omega_n)|$ mindestens $0{,}25 \cdot |\underline{G}(\omega_i)|$ beträgt. Für die Annäherung durch den i-ten Schwingkreis nach FIG 40 werden zwischen der Resonanzfrequenz $\omega_i$ und den jeweils benachbarten Maxima alle monoton steigenden Werte mit Ausnahme des jeweiligen Höchstwertes herangezogen, denn FIG 40 macht deutlich, daß die jeweiligen Höchstwerte (n-4) und (n+3) bereits stark von den benachbarten Resonanzstellen beeinflußt sind. Für gut gedämpfte Resonanzen (flache Extrema) genügen bereits Meßbereiche, die zehn Meßpunkte umfassen. Für sehr schwache Dämpfungen (steile Extrema) müssen mindestens 3 Meßpunkte in der Nähe der Resonanzfrequenz verbleiben.

Diesen Kriterien hielten Resonanzen, die in FIG 43 z.B. bei $n \approx 60$, $n \approx 120$ und $n \gg 180$ vermutet werden können, nicht stand. FIG 44 zeigt den entsprechenden Verlauf der Modell-Übertragungsfunktion $|\underline{Z}$-

$(\omega_n)|$, der 8 Resonanzstellen enthält. Dies entspricht einem Modell mit 8 Schwingkreisen und entsprechend 24 Resonanzparametern.

Diese Resonanzparameter werden als Meßgrößen von einem entsprechenden Identifikationsrechner ausgegeben und können für die Berechnung optimierter Zündwinkel zum Betrieb des Stromrichters weiter verwendet werden.

**Patentansprüche**

1. Verfahren zur Bestimmung von Meßgrößen (Li, Ci, Ri) für Resonanzen in einem Versorgungsnetz (FS, O), dessen momentane Impedanz unbekannt ist und das über einen Abgriff (S) mit einem netzseitigen Anschluß eines Stromrichtergerätes (DC) verbunden ist, mit folgenden Merkmalen:

   a) zumindest innerhalb einer Periode einer vorgegebenen Grundfrequenz werden fortlaufend zwischen dem netzseitigen Anschluß des Stromrichtergerätes und dem Abgriff am Netz eine Oberschwingungen anregende erste elektrische Größe (In;Us) erfaßt und eine zweite elektrische Größe (Un), deren Wert sich entsprechend der unbekannten Impedanz und der ersten elektrischen Größe einstellt, gemessen,

   b) für diese elektrischen Größe wird die Übertragungsfunktion $(F(\omega) = U(\omega)/I(\omega); G(\omega) = Un(\omega)/Us(\omega))$ in Abhängigkeit von den in den Größen enthaltenen harmonischen Oberfrequenzen $(\omega)$ gebildet,

   c) an diese Übertragungsfunktion wird eine Modell-Übertragungsfunktion $(Z(\omega))$ angenähert, die dem Verhalten eines virtuellen Netzmodelles aus Schwingkreisen entspricht, die jeweils nur aus einem Widerstand (Ri), einer Kapazität (Ci) und einer Induktivität (Li) bestehen, und

   d) die Meßgrößen werden aus der angenäherten Modell-Übertragungsfunktion entnommen.

2. Verfahren nach Anspruch 1, **dadurch gekennzeichnet,** daß die Erfassung der ersten Größe und die Messung der zweiten Größe in aufeinander folgenden Perioden wiederholt wird, daß in jeder Periode die Fourierkoeffizienten der Größe bestimmt werden, daß durch eine Mittelung über korrespondierende Fourierkoeffizienten gemittelte Fourierkoeffizienten gebildet werden und daß als Übertragungsfunktion ein aus den gemittelten Fourierkoeffizienten

$$(\overline{Gns}(\omega_n),$$

$\overline{Gss}(\omega_n))$ gebildete geglättete Übertragungsfunktion

$$(\overline{G}(\omega_n))$$

gebildet wird.

3. Verfahren nach Anspruch 1, **dadurch gekennzeichnet,** daß die Übertragungsfunktion als Quotient der Beträge der Fourier-Transformierten der beiden elektrischen Größen gebildet wird.

4. Verfahren nach Anspruch 3, **dadurch gekennzeichnet,** daß zu einer Anzahl von M Zeitpunkten $t_n$ (n = O, I ..., M - I) die Momentanwerte U(tn) der ersten elektrischen Größe und I(tn) der zweiten elektrischen Größe zu komplexen Momentanwerten $\underline{F}$ (tn) = U(tn) + j . I(tn) zusammengesetzt werden, daraus zu den Oberfrequenzen n . $\omega$O der vorgegebenen Grundfrequenz $\omega$O die komplexen Fourierkoeffizienten $\underline{F}$ (n.$\omega$O) mit dem Realteil Re(n) und dem Imaginärteil Im(n) gebildet werden und den Fouriertransformierten $\underline{U}$(n.$\omega$O) und $\underline{I}$(n.$\omega$O) der ersten und zweiten elektrischen Größe die Werte $\underline{U}$ (n.$\omega$) = (Re(n) + Re(M-n))/2 + j . (Im(n)-Im(M-n))/2 und $\underline{I}$ (n) = (Im(n) + Im(M-n))/2 - j . (Re(n)-Re(M-n))/2 zugeordnet werden.

5. Verfahren nach Anspruch 1, **dadurch gekennzeichnet,** daß für die elektrischen Größen die komplexen Fourierkoeffizienten $(\underline{Un}(\omega_n), \underline{Us}(\omega_n))$ gebildet werden, daß aus den komplexen Fourierkoeffizienten Korrelationskoeffizienten $(\underline{Gns}(\omega_n) = \underline{Un}(\omega_n . \underline{Us}^*(\omega_n))$ und Normierungskoeffizienten $(Gss(\omega_n) = \underline{Us}(\omega_n) . \underline{Us}^*(\omega_n))$ gebildet werden und als Übertragungsfunktion für jede Harmonische $(\omega_n)$ jeweils der Quotient beider Koeffizienten $(\underline{G}(\omega_n) = \underline{Gns}(\omega_n)/Gss(\omega_n))$ gebildet wird.

**6.** Verfahren nach Anspruch 5, **dadurch gekennzeichnet,** daß für jede der beiden elektrischen Größen die Normierungskoeffizienten ($\overline{Gnn(\omega_n)}, \overline{Gss(\omega_n)}$) gebildet werden, daß für jede Harmonische ein Plausibilitätsfaktor ($P(\omega_n) = G$) daß in mehreren aufeinanderfolgenden Perioden für jede Harmonische die Normierungskoeffizienten für jede elektrische Größe und des Quadrat des Korrelationskoeffizienten gebildet und über die aufeinanderfolgenden Perioden gemittelt werden und daß daraus für jede Harmonische ein Plausibilitätsfaktor errechnet wird, um die Modell-Übertragungsfunktion nur an plausible Werte der Übertragungsfunktion anzunähern.

**7.** Verfahren nach Anspruch 1 , **dadurch gekennzeichnet,** daß die Modell-Übertragungsfunktion nur an Werte der aus den Meßwerten errechneten Übertragungsfunktion angenähert wird, die vorgegebene Plausibilitätskriterien erfüllen.

**8.** Verfahren nach Anspruch 1, **dadurch gekennzeichnet,** daß die Zahl (N) der Schwingkreise des virtuellen Modells aus der Zahl der Extrema der Übertragungsfunktion bestimmt wird.

**9.** Verfahren nach Anspruch 1, **dadurch gekennzeichnet,** daß zur Annäherung nur der Verlauf der Modell-Übertragungsfunktion im Bereich von Extreme an den Verlauf der Übertragungsfunktion angenähert wird.

**10.** Verfahren nach Anspruch 9, **dadurch gekennzeichnet,** daß die Meßgrößen einer Resonanzfrequenz durch Bestimmung der Frequenz und Bandbreite eines Maximums oder Minimums der Übertragungsfunktion gebildet werden.

**11.** Verfahren nach Anspruch 9, **dadurch gekennzeichnet,** daß die Parameter für Widerstand, Kapazität und Induktivität oder die Resonanzfrequenz und dessen Bandbreite und Dämpfung eines Schwingkreises des virtuellen Modells aus der Frequenz, Amplitude und Bandbreite eines Extremums der Modell-Übertragungsfunktion gebildet und als Meßgröße ausgegeben werden.

**12.** Verfahren nach Anspruch 11, **dadurch gekennzeichnet,** daß zunächst aus Amplituden, Bandbreiten und Frequenzen jeweils die Übertragungsfunktionen isolierter virtueller Schwingkreise gebildet werden, für einen isolierten virtuellen Schwingkreis die Summe der Übertragungsfunktionen der anderen isolierten Schwingkreise gebildet wird, eine reduzierte isolierte Übertragungsfunktion des Schwingkreises dadurch gebildet wird, daß diese Summe von der Modell-Übertragungsfunktion subtrahiert wird, und die Meßgrößen aus Frequenz, Amplitude und Bandbreite der reduzierten isolierten Übertragungsfunktion bestimmt werden.

**13.** Verfahren nach Anspruch 1, **dadurch gekennzeichnet,** daß die Ermittlung der ersten Größe und die Messung der zweiten Größe in einem auf die Grundfrequenz synchronisierten, hochfrequenten Takt in äquidistanten Abständen innerhalb einer oder mehreren Grundperioden vorgenommen wird, daraus die Meßgrößen ermittelt und in einen Speicher eingelesen werden und anschließend der Vorgang in folgenden Grundperioden wiederholt wird.

**14.** Verfahren nach Anspruch 13, **dadurch gekennzeichnet,** daß die Modell-Übertragungsfunktion dadurch gebildet wird, daß für eine z-Übertragungsfunktion mit einer vorgegebenen Anzahl von Parametern durch iterativen Vergleich mit den beiden elektrischen Größen die Parameter bestimmt werden und daß die Modell-Übertragungsfunktion aus der funktionalen Abhängigkeit dieser z-Übertragungsfunktion bestimmt wird.

**15.** Verfahren nach Anspruch 1, **dadurch gekennzeichnet,** daß als elektrische Größen die Spannung des Netzes und der ins Netz eingespeiste Strom gemessen und daraus das Frequenzspektrum der Impedanz oder des Wechselstrom-Leitwertes des Netzes als Übertragungsfunktion ermittelt wird.

**16.** Verfahren nach Anspruch 1, **dadurch gekennzeichnet,** daß als erste elektrische Größe die einem zwischen dem Stromrichter und dem Netz angeordneten Impedanzelement eingeprägte Ausgangsspannung des Stromrichters ermittelt und als zweite elektrische Größe die Spannung am Anschluß des Netzes gemessen wird und daß als Übertragungsfunktion das Frequenzspektrum der Übertragungsfunktion des Netzes ermittelt wird.

17. Anwendung des Verfahrens nach Anspruch 1, wobei

a) die Meßgrößen zusammen mit Sollwerten für die erste elektrische Größe einem Optimierungsrechner eingegeben werden,

b) der Optimierungsrechner virtuellen Schaltzeitpunkten für die Schalteinrichtung des Stromrichters
einen Betriebszustand des virtuellen Modells unter der Annahme zuordnet, daß das virtuelle Modell
anstelle des Netzes an den Stromrichter angeschlossen und die Schalteinrichtungen des Stromrichters zu den virtuellen Schaltzeitpunkten betätigt werden, und durch Variation der virtuellen Schaltzeitpunkte einen optimalen Betriebszustand errechnet, bei dem eine dem virtuellen Betriebszustand
entsprechende Funktion der Schaltzeitpunkte ein Optimierungskriterium erfüllt, und

c) daß zu den dem optimalen Betriebszustand des Wechselrichters entsprechenden virtuellen
Schaltzeitpunkten die Schalteinrichtungen des Stromrichters betätigt werden.

18. Recheneinrichtung zur Ausführung des Verfahrens nach Anspruch 1 zur Bildung von Meßgrößen für
Resonanzerscheinungen eines Netzes, dessen momentane Impedanz unbekannt ist und das über einen
Abgriff an einen Stromrichter angeschlossen ist, mit folgenden Merkmalen:

a) eine Synchronisiereinrichtung erfaßt eine den Betrieb des Stromrichters steuernde Grundfrequenz
und steuert Abtastmittel, die innerhalb einer Periode der Grundfrequenz zu äquidistanten Abtastzeitpunkten die Momentanwerte zweier unterschiedlicher elektrischer Größen am Abgriff ermitteln,

b) für Oberfrequenzen der Grundfrequenz, die in einem vorgegebenen Frequenzbereich liegen,
errechnet eine erste Rechenstufe eine Übertragungsfunktion, die eine Funktion der Ordnung dieser
Oberfrequenzen ist und einen Quotienten zweier Größen angibt, die für die beiden elektrischen
Größen jeweils den Fourier-Koeffizienten dieser Ordnung entsprechen,

c) eine zweite Rechenstufe ermittelt daraus die Parameter fiktiver, jeweils aus einem Widerstand,
einem Kondensator und einem Impedanzelement bestehender Schwingkreise, die ein virtuelles
Modell mit einer Modell-Übertragungsfunktion bilden, wobei zumindest ausgewählte Extrema der
Übertragungsfunktion mit Extrema der Modell-Übertragungsfunktion übereinstimmen, und

d) die Parameter der virtuellen Schwingkreise werden als Meßgrößen ausgegeben.

19. Recheneinrichtung nach Anspruch 18, **dadurch gekennzeichnet,** daß die Abtastmittel eine erste
Abtasteinrichtung für die Spannung am Abgriff und eine zweite Abtasteinrichtung für den über den
Abgriff ins Netz eingespeisten Strom enthalten.

20. Recheneinrichtung nach Anspruch 18, **dadurch gekennzeichnet,** daß im Abgriff zwischen Stromrichter und Netzanschluß ein Impedanzelement angeordnet ist und die Abtastmittel eine erste Abtasteinrichtung für die Spannung, die vom Stromrichter dem Impedanzelement eingeprägt wird, und eine
zweite Abtasteinrichtung für die am netzseitigen Ende des Impedanzelementes auftretende Spannung
enthält.

21. Recheneinrichtung nach Anspruch 18, **dadurch gekennzeichnet,** daß die erste Rechenstufe Mittel
zum Unterdrücken nicht-plausibler Werte des Quotienten enthält.

22. Recheneinrichtung nach Anspruch 18, **dadurch gekennzeichnet,** daß die zweite Rechenstufe Mittel
zur Bestimmung der Frequenz und des Betrages von Minima oder Maxima der Übertragungsfunktion
enthält.

23. Recheneinrichtung nach Anspruch 22, **dadurch gekennzeichnet,** daß die zweite Rechenstufe ferner
Mittel zur Bestimmung der Bandbreite und Dämpfung der Minima oder Maxima enthält.

24. Recheneinrichtung nach Anspruch 23, **dadurch gekennzeichnet,** daß am Ausgang der zweiten
Rechenstufe ein Speicher angeordnet ist, in dem als Meßgrößen der Betrag, die Frequenz und die
Bandbreite der Minima bzw. Maxima oder die Parameter der virtuellen Widerstände, Kapazitäten und
Induktivitätselemente jeweils bis zur Neuberechnung dieser Meßgrößen gespeichert werden.

**Claims**

1. Method for determining measured variables (Li, Ci, Ri) for resonances in a supply system (FS, O), the
instantaneous impedance of which is unknown and which is connected by way of a tap (S) to a supply
terminal of a converter assembly (DC), having the following features:

a) at least within a period of a specified fundamental frequency, continuously between the supply terminal of the converter assembly and the tap at the system a first electrical variable (In;Us) exciting harmonica is detected and a second electrical variable (Un), the value of which is set according to the unknown impedance and the first electrical variable, is measured,

b) for these electrical variables the transfer function ($F(\omega) = U(\omega)/I(\omega); G(\omega) = Un(\omega)/Us(\omega)$) is formed in dependence upon the harmonic upper frequencies ($\omega$) contained in the variables,

c) a model transfer function ($Z(\omega)$) is approximated to this transfer function, the model transfer function corresponding to the behaviour of a virtual network analyzer of oscillating circuits which in each case only consist of a resistance ($Ri$), a capacitance ($Ci$) and an inductance ($Li$), and

d) the measured variables are taken from the approximated model transfer function.

2. Method according to claim 1, characterized in that the detection of the first variable and the measurement of the second variable is repeated in successive periods, in that in each period the Fourier coefficients of the variable are determined, in that by means of an averaging, Fourier coefficients averaged by way of corresponding Fourier coefficients are formed and in that a smoothed transfer function

$$(\overline{\underline{G}}(\omega_n)$$

formed from the averaged Fourier coefficients

$$(\overline{\underline{Gns}}(\omega_n),$$

$\overline{Gss}(\omega_n)$) is formed as transfer function.

3. Method according to claim 1, characterized in that the transfer function is formed as quotient of the magnitudes of the Fourier transforms of the two electrical variables.

4. Method according to claim 3, characterized in that for a number of M instants $t_n$ ($n = 0, 1 ..., M - 1$) the instantaneous values U(tn) of the first electrical variable and I(tn) of the second electrical variable are assembled into complex instantaneous values $\underline{F}$ (tn) = U(tn) + j . I(tn), from these for the upper frequencies n . $\omega O$ of the specified fundamental frequency $\omega O$ the complex Fourier coefficients $\underline{F}$ (n.$\omega O$) with the real part Re(n) and the imaginary part Im(n) are formed and there are associated with the Fourier transforms $\underline{U}$(n.$\omega O$) and $\underline{I}$(n.$\omega O$) of the first and second electrical variable the values $\underline{U}$ (n.$\omega$) = (Re(n) + Re(M-n))/2 + j . (Im(n)-Im(M-n))/2 and $\underline{I}$ (n) = (Im(n)+Im(M-n))/2 - j . (Re(n)-Re(M-n))/2.

5. Method according to claim 1, characterized in that for the electrical variables the complex Fourier coefficients ($\underline{Un}(\omega_n),\underline{Us}(\omega_n)$) are formed, in that from the complex Fourier coefficients correlation coefficients ($\underline{Gns}(\omega_n) = \underline{Un}(\omega_n . \underline{Us}^*(\omega_n)$) and scaling coefficients ($Gss(\omega_n) = \underline{Us}(\omega_n) . \underline{Us}^*(\omega_n)$) are formed and in each case the quotient of both coefficients ($\underline{G}(\omega_n) = \underline{Gns}(\omega_n)/Gss(\omega_n)$) is formed as transfer function for each harmonic ($\omega_n$).

6. Method according to claim 5, characterized in that for each of the two electrical variables the scaling coefficients ($\overline{Gnn}(\omega_n),\overline{Gss}(\omega_n)$) are formed, in that for each harmonic a plausibility factor ($P(\omega_n) = G$) [sic], in that in several successive periods for each harmonic the scaling coefficients for each electrical variable and the square of the correlation coefficient are formed and are averaged over the successive periods and in that from this for each harmonic a plausibility factor is calculated in order to approximate the model transfer function only to plausible values of the transfer function.

7. Method according to claim 1, characterized in that the model transfer function is only approximated to those values of the transfer function calculated from the measured values which fulfil specified plausibility criteria.

8. Method according to claim 1, characterized in that the number (N) of the oscillating circuits of the virtual model is determined from the number of extremes of the transfer function.

9. Method according to claim 1, characterized in that for the approximation only the form of the model transfer function in the region of extremes is approximated to the form of the transfer function.

10. Method according to claim 9, characterized in that the measured variables of a resonant frequency are formed by determining the frequency and bandwidth of a maximum or minimum of the transfer function.

11. Method according to claim 9, characterized in that the parameters for resistance, capacitance and inductance or the resonant frequency and its bandwidth and attenuation of an oscillating circuit of the virtual model are formed from the frequency, amplitude and bandwidth of an extreme of the model transfer function and are issued as measured variable.

12. Method according to claim 11, characterized in that initially in each case the transfer functions of isolated virtual oscillating circuits are formed from amplitudes, bandwidths and frequencies, for an isolated virtual oscillating circuit the sum of the transfer functions of the other isolated oscillating circuits is formed, a reduced isolated transfer function of the oscillating circuit is formed by this sum being subtracted from the model transfer function, and the measured variables are determined from frequency, amplitude and bandwidth of the reduced isolated transfer function.

13. Method according to claim 1, characterized in that the determination of the first variable and the measurement of the second variable is undertaken in a high-frequency cycle synchronized with the fundamental frequency at equidistant intervals within one or more fundamental periods, from this the measured variables are determined and are read into a memory and subsequently the procedure is repeated in ensuing fundamental periods.

14. Method according to claim 13, characterized in that the model transfer function is formed by the parameters being determined by way of iterative comparison with the two electrical variables for a z transfer function with a specified number of parameters, and in that the model transfer function is determined from the functional dependence of this z transfer function.

15. Method according to claim 1, characterized in that the voltage of the system and the current supplied into the system are measured as electrical variables and from this the frequency spectrum of the impedance or the a.c. conductivity of the system is determined as transfer function.

16. Method according to claim 1, characterized in that the output voltage of the converter applied to an impedance element arranged between the converter and the system is determined as first electrical variable and the voltage at the terminal of the system is measured as second electrical variable and in that the frequency spectrum of the transfer function of the system is determined as transfer function.

17. Use of the method according to claim 1, in which
   a) the measured variables are entered together with desired values for the first electrical variable into an optimization computer,
   b) the optimization computer allocates to virtual switching instants for the switching device of the converter an operating state of the virtual model on the assumption that instead of the system the virtual model is attached to the converter and the switching devices of the converter are actuated at the virtual switching instants, and by way of variation of the virtual switching instants calculates an optimal operating state where a function of the switching instants corresponding to the virtual operating state fulfils an optimization criterion, and
   c) the switching devices of the converter are actuated at the virtual switching instants corresponding to the optimal operating state of the inverter.

18. Computing device for carrying out the method according to claim 1 for the formation of measured variables for resonance phenomena of a system, the instantaneous impedance of which is unknown and which is attached by way of a tap to a converter, having the following features:
   a) a synchronizing device detects a fundamental frequency controlling the operation of the converter and controls scanning means which determine the instantaneous values of the two different electrical variables at the tap within a period of the fundamental frequency at equidistant scanning instants,

25

b) for upper frequencies of the fundamental frequency which lie in a specified frequency range a first computing stage calculates a transfer function, which is a function of the order of these upper frequencies and indicates a quotient of the two variables, which for the two electrical variables in each case correspond to the Fourier coefficients of this order,

c) a second computing stage determines from this the parameters of hypothetical oscillating circuits, in each case consisting of a resistance, a capacitor and an impedance element, which form a virtual model with a model transfer function, with at least selected extremes of the transfer function corresponding with extremes of the model transfer function, and

d) the parameters of the virtual oscillating circuits are issued as measured variables.

19. Computing device according to claim 18, characterized in that the scanning means comprise a first scanning device for the voltage at the tap and a second scanning device for the current supplied by way of the tap into the system.

20. Computing device according to claim 18, characterized in that an impedance element is arranged in the tap between the converter and the system terminal and the scanning means comprise a first scanning device for the voltage, which is applied by the converter to the impedance element, and a second scanning device for the voltage occurring at the supply end of the impedance element.

21. Computing device according to claim 18, characterized in that the first computing stage contains means for the suppression of non-plausible values of the quotient.

22. Computing device according to claim 18, characterized in that the second computing stage contains means for determining the frequency and the magnitude of minima or maxima of the transfer function.

23. Computing device according to claim 22, characterized in that, moreover, the second computing stage contains means for determining the bandwidth and attenuation of the minima or maxima.

24. Computing device according to claim 23, characterized in that a memory is arranged at the output of the second computing stage, in which memory the magnitude, the frequency and the bandwidth of the minima and maxima or the parameters of the virtual resistances, capacitances and inductance elements are in each case stored as measured variables until these measured variables are calculated anew.

**Revendications**

1. Procédé pour déterminer des grandeurs de mesure (Li, Ci, Ri) pour des résonances dans un réseau d'alimentation (FS, 0), dont l'impédance instantanée est inconnue et qui est raccordé par l'intermédiaire d'une prise (S) à une borne, située côté réseau, d'un convertisseur statique (DC), présentant les caractéristiques suivantes :

a) au moins pendant une période d'une fréquence de base prédéterminée, une première grandeur électrique (In;Us), qui déclenche la production d'harmoniques est détectée en permanence entre la borne, située côté réseau, du convertisseur statique et la prise de raccordement au réseau, et une seconde grandeur électrique (Un), dont la valeur se règle en fonction de l'impédance inconnue de la première grandeur électrique, est mesurée,

b) pour cette grandeur électrique, la fonction de transfert ($F\omega = U(\omega)/I(\omega); G(\omega) = Un(\omega)/Us(\omega)$) est formée en fonction des fréquences supérieures harmoniques ($\omega$) contenues dans les grandeurs,

c) cette fonction de transfert est approximée au moyen d'une fonction de transfert modèle ($Z(\omega)$), qui correspond au comportement d'un modèle virtuel du réseau formé par les circuits oscillants, qui sont constitués chacun uniquement par une résistance (Ri), une capacité (Ci) et une inductance (Li), et

d) les grandeurs de mesure sont prélevées de la fonction de transfert modèle approximée.

2. Procédé suivant la revendication 1, caractérisé par le fait que la détection de la première grandeur et la mesure de la seconde grandeur sont répétées pendant des périodes successives, que les coefficients de Fourier des grandeurs sont déterminés pendant chaque période, que des coefficients de Fourier moyens sont formés par formation de la moyenne de coefficients de Fourier correspondants, et qu'en tant que fonction de transfert est formée une fonction de transfert

$$(\overline{\underline{G}}(\omega_n))$$

lissée, formée à partir des coefficients de Fourier moyens $(\overline{\underline{Gns}}(\omega_n), \overline{\underline{Gss}}(\omega_n))$.

3. Procédé suivant la revendication 1, caractérisé par le fait que la fonction de transfert est formée en tant que quotient des valeurs absolues des transformées de Fourier des deux grandeurs électriques.

4. Procédé suivant la revendication 3, caractérisé par le fait qu'un nombre de M instants $t_n$ (n = 0, 1 ...,M-1), et les valeurs instantanées U(tn) de la première grandeur électrique et I(tn) de la seconde grandeur électrique sont réunies pour former des valeurs instantanées complexes $\underline{F}(tn) = U(tn) + j . I(tn)$, que le coefficient de Fourier complexe $\underline{H}(n.\omega0)$ possédant la partie réelle Re(n) et la partie imaginaire Im(n) sont formées à partir de là pour les fréquences harmoniques $n.\omega0$ de la fréquence de base prédéterminée $\omega0$, et qu'aux transformées de Fourier $\underline{U}(n.\omega0)$ et $\underline{I}(n.\omega0)$ des première et seconde grandeurs électriques sont associées les valeurs $\underline{U}(n.\omega) = (Re(n) + Re(M-n))/2 + j . (Im(n)-Im(M-n))/2$ et $\underline{I}(n) = (Im(n) + Im(M-n))/2 - j . (Re(n)-Re(M-n))/2$.

5. Procédé suivant la revendication 1, caractérisé par le fait que pour les grandeurs électriques on forme les coefficients de Fourier complexes $(\underline{Un}(\omega_n),\underline{Us}(\omega_n))$, à partir des coefficients de Fourier complexes on forme des coefficients de corrélation $(\underline{Gns}(\omega_n) = \underline{Un}(\omega_n . Us^*(\omega_n)))$ et des coefficients de normalisation $(\underline{Gss}(\omega_n) = \underline{Us}(\omega_n . Us^*(\omega_n)))$, et on forme, en tant que fonction de transfert pour chaque harmonique $(\omega_n)$, respectivement le quotient des deux coefficients $(\underline{G}(\omega_n) = \underline{Gns}(\omega_n)/Gss(\omega_n))$.

6. Procédé suivant la revendication 5, caractérisé par le fait que pour chacune des deux grandeurs électriques, on forme les coefficients de normalisation $(\overline{Gnn}(\omega_n), \overline{Gss}(\omega_n))$, que pour chaque harmonique, on forme un facteur de vraisemblance $(P(\omega_n) = G)$, que pendant plusieurs périodes successives on forme, pour chaque harmonique, les coefficients d'harmonisation pour chaque grandeur électrique et le carré du coefficient de corrélation et qu'on en forme la moyenne sur les périodes successives, et qu'à partir de là on calcule un facteur de vraisemblance pour chaque harmonique, de manière que la fonction de transfert modèle approxime uniquement des valeurs plausibles de la fonction de transfert.

7. Procédé suivant la revendication 1, caractérisé par le fait que la fonction de transfert modèle approxime uniquement des valeurs de la fonction de transfert calculée à partir des valeurs de mesure, qui satisfont à des critères prédéterminés de vraisemblance.

8. Procédé suivant la revendication 1, caractérisé par le fait que le nombre (N) des circuits oscillants du modèle virtuel est déterminé par le nombre des extrêma de la fonction de transfert.

9. Procédé suivant la revendication 1, caractérisé par le fait que pour l'approximation, la variation de la fonction de transfert modèle approxime, dans la zone d'extrêma, la variation de la fonction de transfert.

10. Procédé suivant la revendication 9, caractérisé par le fait que les grandeurs de mesure possédant une fréquence de résonance sont formées par détermination de la fréquence et de la largeur de bande d'un maximum et d'un minimum de la fonction de transfert.

11. Procédé suivant la revendication 9, caractérisé par le fait que les paramètres pour la résistance, la capacité et l'inductance ou la fréquence de résonance et sa largeur de bande et l'amortissement du circuit oscillant du modèle virtuel, sont formés à partir de la fréquence, de l'amplitude, de la largeur de bande d'un extremum de la fonction de transfert modèle et sont délivrés en tant que grandeur de mesure.

12. Procédé suivant la revendication 11, caractérisé par le fait qu'on forme tout d'abord à partir d'amplitudes, de largeurs de bandes et de fréquences, respectivement les fonctions de transfert de circuits oscillants virtuels isolés, que pour un circuit oscillant virtuel isolé on forme la somme des fonctions de transfert des autres circuits oscillants isolés, qu'on forme une fonction de transfert isolée réduite du circuit oscillant en soustrayant cette somme de la fonction de transfert modèle, et qu'on détermine les grandeurs de mesure à partir de la fréquence, de l'amplitude et de la largeur de bande de la fonction de transfert isolée réduite.

EP 0 491 691 B1

**13.** Procédé suivant la revendication 1, caractérisé par le fait que la détermination de la première grandeur et la mesure de la seconde grandeur est exécutée à une cadence à haute fréquence, synchronisée sur la fréquence de base, à des intervalles équidistants à l'intérieur d'une ou de plusieurs périodes de base, qu'on détermine à partir de là des grandeurs de mesure et qu'on les mémorise dans une mémoire et qu'ensuite on répète le processus pendant des périodes de base suivantes.

**14.** Procédé suivant la revendication 13, caractérisé par le fait qu'on forme la fonction de transfert modèle en déterminant les paramètres pour une fonction de transfert z possédant un nombre prédéterminé de paramètres, par comparaison itérative aux deux grandeurs électriques, et qu'on détermine la fonction de transfert modèle à partir de la dépendance fonctionnelle de cette fonction de transfert z.

**15.** Procédé suivant la revendication 1, caractérisé par le fait qu'on mesure, en tant que grandeurs électriques, la tension du réseau et le courant injecté dans le réseau et qu'on détermine, à partir de là, le spectre de fréquences de l'impédance ou la valeur de conduction du réseau pour le courant alternatif en tant que fonction de transfert.

**16.** Procédé suivant la revendication 1, caractérisé par le fait qu'on détermine, comme première grandeur électrique, la tension de sortie du convertisseur statique dans un élément d'impédance disposé entre le convertisseur statique et le réseau, et qu'on mesure en tant que seconde grandeur électrique la tension sur la borne du réseau et qu'on détermine, comme fonction de transfert, le spectre de fréquences de la fonction de transfert du réseau.

**17.** Utilisation du procédé suivant la revendication 1, selon laquelle
a) les grandeurs de mesure sont introduites, conjointement avec des valeurs de consigne pour la première grandeur électrique, dans un calculateur d'optimisation,
b) le calculateur d'optimisation associe à des instants virtuels de commutation pour le dispositif de commutation du convertisseur statique, un tel fonctionnement du mode virtuel dans l'hypothèse où le mode virtuel est raccordé à la place du réseau au convertisseur statique et où les dispositifs de commutation du convertisseur statique sont actionnés aux instants virtuels de commutation, et calcule, par modification des instants virtuels de commutation, un état optimal de fonctionnement, pour lequel une fonction des instants de commutation, qui correspond à l'état de fonctionnement virtuel, satisfait à un critère d'optimisation, et
c) qu'aux instants virtuels de commutation, qui correspondent à l'état de fonctionnement optimal de l'onduleur, les dispositifs de commutation et le convertisseur statique sont actionnés.

**18.** Dispositif de calcul pour la mise en oeuvre du procédé suivant la revendication 1 pour la formation de grandeurs de mesure pour des phénomènes de résonance d'un réseau, dont l'impédance instantanée est inconnue et qui est raccordé par l'intermédiaire d'une prise à un convertisseur statique, présentant les caractéristiques suivantes :
a) un dispositif de synchronisation détecte une fréquence de base, qui commande le fonctionnement du convertisseur statique et commande les moyens d'échantillonnage, qui, pendant une période de la fréquence de base déterminent, à des instants d'échantillonnage équidistants, les valeurs instantanées des deux grandeurs électriques différentes présentes sur la prise, et
b) pour des fréquences harmoniques de la fréquence de base, qui sont situées dans une gamme prédéterminée de fréquences, un premier étage de calcul calcule une fonction de transfert, qui est fonction de l'ordre de ces fréquences harmoniques et indique un quotient de deux grandeurs, qui correspondent, pour les deux grandeurs électriques, respectivement aux coefficients de Fourier de cet ordre,
c) un second étage de calcul calcule, à partir de là, les paramètres de circuits oscillants fictifs, constitués chacun par une résistance, un condensateur et un élément d'impédance et qui forment un modèle virtuel possédant une fonction de transfert modèle, auquel cas au moins un des extrêma sélectionnés de la fonction de transfert coïncide avec des extrêma de la fonction de transfert modèle, et
d) les paramètres des circuits oscillants virtuels sont délivrés en tant que grandeurs de mesure.

**19.** Dispositif de calcul suivant la revendication 18, caractérisé par le fait que les moyens d'échantillonnage comportent un premier dispositif d'échantillonnage pour la tension présente sur la prise et un second dispositif d'échantillonnage pour le courant détecté dans le réseau par l'intermédiaire de la prise.

28

**20.** Dispositif de calcul suivant la revendication 18, caractérisé par le fait qu'un élément d'impédance est disposé dans la prise entre le convertisseur statique et la borne du réseau et que les moyens d'échantillonnage contiennent un premier dispositif d'échantillonnage pour la tension, qui est injectée par le convertisseur statique dans l'élément d'impédance, et un second dispositif d'échantillonnage pour la tension qui apparaît sur l'extrémité, côté réseau, de l'élément d'impédance.

**21.** Dispositif de calcul suivant la revendication 18, caractérisé par le fait que le premier étage de calcul comporte des moyens pour supprimer des valeurs non vraisemblables du quotient.

**22.** Dispositif de calcul suivant la revendication 18, caractérisé par le fait que le second étage de calcul comporte des moyens pour déterminer la fréquence et la valeur absolue de minima ou de maxima de la fonction de transfert.

**23.** Dispositif de calcul suivant la revendication 22, caractérisé par le fait que le second étage de calcul comporte en outre des moyens pour déterminer la largeur de bande et l'affaiblissement des minima ou des maxima.

**24.** Dispositif de calcul suivant la revendication 23, caractérisé par le fait qu'à la sortie du second étage de calcul est disposée une mémoire, dans laquelle sont mémorisées, en tant que grandeurs de mesure, la valeur absolue, la fréquence et la largeur de bande des minima ou des maxima ou les paramètres des résistances virtuelles, des capacités virtuelles et des éléments d'inductance virtuels, respectivement jusqu'au nouveau calcul de ces grandeurs de mesure.

FIG 1

FIG 2

FIG 3

FIG 4

FIG 5

FIG 6

FIG 7

FIG 10

FIG 11

FIG 12

FIG 8

FIG 9

EP 0 491 691 B1

FIG 13

FIG 14

FIG 15

34

FIG 16

FIG 17

FIG 18

START

n=0
ANMAX=0

n=n+1

Calcul. ANB($n\omega_0$)
Calcul. REB($n\omega_0$)

ANB($n\omega_0$) > ANMAX?  →  Yes  →  ANMAX=ANB($k\omega_0$)

No

n > N

ANMIN = ANMAX · ANRMIN

n=0

n=n+1

Yes ← ANB($n\omega_0$) > ANMIN → No

$$Z(n\omega_0) = \frac{REB(n\omega_0)}{ANB(n\omega_0)}$$

Z($n\omega_0$)=0,0

No

n > N

RETURN

FIG 19

EP 0 491 691 B1

FIG 20

FIG 22

FIG 24

FIG 25

37

FIG 21A

FIG 21B

FIG 21

READ:$(\omega_k)$

$k = DMAX$

Yes → RETURN

$k > M{-}DMAX$

$k = k{+}1$

$Z(\omega_s)$ maximal → No

$j = k$

DECREMENT j UNTIL:
$Z(\omega_j) < Z(\omega_s)/\sqrt{2}$
OR $Z(\omega_j) > Z(\omega_s)$ OR $j=0$

$Z(\omega_j) > Z(\omega_k)$ → Yes

$\omega_u = \omega_j$

DECREMENT j UNTIL:
$Z(\omega_j) > 0$ OR $j=0$

No ← $Z(\omega_j) < Z(\omega_u)$

FIG 21A

j=k

INCREMENT j UNTIL:
$Z(\omega_j) < Z(\omega_s)/\sqrt{2}$
OR $Z(\omega_j) > Z(\omega_s)$ OR j=M

$Z(\omega_j) > Z(\omega_s)$ — No

$\omega_a = \omega_k$

INCREMENT j UNTIL:
$Z(\omega_j) > 0$ OR j=M

No — $Z(\omega_j) < Z(\omega_s)$

STORE: $\omega_k = \omega_j$

FIG 21B

READ: $\omega_i$; MAXi → i=1

i=i+1

i > MAXi

Yes

RETURN

j=i

DECREMENT j UNTIL:
$Z(\omega_j) < Z(\omega_i)/\sqrt{2}$    OR   j=0

$\omega_{u1} = j \cdot \omega_0$

DECREMENT j UNTIL:
$Z(\omega_j) > 0$    OR  j=0

$Z(\omega_j) < Z(\omega_{u1})$

No

INCREMENT j UNTIL:
$Z(\omega_j) \neq 0$   AND   $Z(\omega_j) > Z(\omega_i)/\sqrt{2}$

$\omega_{u0} = j \cdot \omega_0$

CALCULATE: $\omega_u = u \cdot \omega_0$

j=i

INCREMENT i UNTIL:
$Z(\omega_j) < Z(\omega_i)/\sqrt{2}$  OR   j=M

$\omega_{ao} = j \cdot \omega_0$

INCREMENT j UNTIL:
$Z(\omega_j) \neq 0$  OR   j=M

No

$Z(\omega_j) < Z(\omega_{ao})$

FIG 23A

FIG 23B

FIG 23

FIG 23A

DECREMENT j UNTIL:
$Z(\omega_j) \neq 0$   AND   $Z(\omega_j) > Z(\omega_j)/\sqrt{2}$

$\omega_{au} = j \cdot \omega_0$

CALCULATE: $\omega_a = a \cdot \omega_0$

STORE: $D\omega = \omega_u - \omega_a$

FIG 23B

$$|Z(\omega)| = |\Sigma_i Z_i(\omega)|$$

(i=1)

(i=2)

(i=3)

$\omega_1$   $\omega_2$   $\omega_3$   $\omega$

FIG 26

$$|\underline{Z}_2^{(n+1)}(\omega)| \quad F(\omega)$$

$$|\underline{Z}^{(n)}(\omega) - \underline{Z}_2^{(n)}(\omega)|$$

$\omega_1$   $\omega_2$   $\omega_3$   $\omega$

FIG 27

FIG 28

FIG 29

FIG 30

FIG 31

FIG 32

FIG 33

$$n=\frac{\omega_n}{\omega_0}$$

Us(t)

FIG 34

t

Is(t)

FIG 35

t

FIG 36

FIG 37

FIG 38

FIG 39

FIG 40

FIG 41

FIG 42

FIG 43

FIG 44